# FASCICULE DE BREVET EUROPEEN

(11) **EP 2 112 211 B1**
(45) Date de publication et mention de la délivrance du brevet: **23.03.2016**
(21) Numéro de dépôt: 09158262.7
(22) Date de dépôt: 20.04.2009
(51) Int. Cl.: C09K 11/02, C09K 11/06, B82Y 20/00, B82Y 30/00, H01L 51/00, H01L 51/50

(54) **PARTICULE DE SILICE COMPRENANT UN COMPOSÉ ORGANO-LANTHANIDE, PROCÉDÉ DE PRÉPARATION ET UTILISATIONS**
QUARZPARTIKEL, DAS EINE ORGANISCHE LANTHANOID-VERBINDUNG ENTHÄLT, SOWIE ENTSPRECHENDES HERSTELLUNGSVERFAHREN UND ENTSPRECHENDE ANWENDUNGEN
PARTICLE OF SILICA COMPRISING AN ORGANOLANTHANIDE COMPOUND, PREPARATION METHOD AND USES

(30) Priorité: 23.04.2008 FR 0852724
(43) Date de publication de la demande: 28.10.2009
(73) Titulaire: Commissariat à l'Énergie Atomique et aux Énergies Alternatives, 75015 Paris (FR)
(72) Inventeur: Raccurt, Olivier, 38730 Chelieu (FR); Imbert, Daniel, 38000 Grenoble (FR); Mazzanti, Marinella, 38950 Saint Martin le Vinoux (FR); Samuel, Jorice, 38220 Vizille (FR)
(74) Mandataire: Augarde, Eric

(56) Documents cités:
- US-A- 5 245 026
- US-A1- 2005 084 451
- OW H ET AL: "Bright and stable core-shell fluorescent silica nanoparticles" NANO LETTERS, ACS, WASHINGTON, DC, US, vol. 5, no. 1, 1 janvier 2005 (2005-01-01), pages 113-117, XP003009815 ISSN: 1530-6984
- TAKALO H ET AL: "SYNTHESIS AND LUMINESCENCE OF NOVEL EUIII COMPLEXING AGENTS AND LABELS WITH 4-(PHENYLETHYNYL)PYRIDINE SUBUNITS" HELVETICA CHIMICA ACTA, VERLAG HELVETICA CHIMICA ACTA. BASEL, CH, vol. 79, no. 3, 1 janvier 1996 (1996-01-01), pages 789-802, XP001002467 ISSN: 0018-019X
- ZIESSEL R ET AL: "Lanthanide probes for luminescence microscopy and anion sensing" JOURNAL OF ALLOYS AND COMPOUNDS, ELSEVIER SEQUOIA, LAUSANNE, CH, vol. 374, no. 1-2, 14 juillet 2004 (2004-07-14), pages 283-288, XP004514947 ISSN: 0925-8388
- GATEAU C ET AL: "Solid-state and soltuion properties of the lanthanide complexes of a new nonadentate tripodal ligand derived from 1,4,7-triazacyclononane" JOURNAL OF THE CHEMICAL SOCIETY, DALTON TRANSACTIONS, CHEMICAL SOCIETY. LETCHWORTH, GB, 20 mai 2003 (2003-05-20), pages 2428-2433, XP002402552 ISSN: 1472-7773
- NONAT A ET AL: "Lanthanide Complexes of a Picolinate Ligand Derived from 1,4,7-Triazacyclononane with Potential Application in Magnetic Resonance Imaging and Time-Resolved Luminescence Imaging" CHEMISTRY - A EUROPEAN JOURNAL, WILEY - V C H VERLAG GMBH & CO. KGAA, WEINHEIM, DE, vol. 12, 6 juin 2006 (2006-06-06), pages 7133-7150, XP002434539 ISSN: 0947-6539
- CROSS J P ET AL: "Studies on some mixed pyrido-phenol donor ligands as sensitisers for terbium (III)" JOURNAL OF LUMINESCENCE, AMSTERDAM, NL, vol. 110, no. 3, 1 novembre 2004 (2004-11-01), pages 101-111, XP004592106 ISSN: 0022-2313

## Description

### DOMAINE TECHNIQUE

La présente invention appartient au domaine des particules de silice nano-structurées.

La présente invention concerne, plus particulièrement, des particules de silice nano-structurées contenant des complexes de lanthanides, leur procédé de préparation et leur utilisation en tant que traceurs multi-luminescents pour une application de marquage anti-contrefaçon et/ou en biotechnologie.

### ÉTAT DE LA TECHNIQUE ANTÉRIEURE

L'idée d'encapsuler des molécules fluorescentes dans de la silice est aujourd'hui assez répandue. De nombreuses communications relatent déjà cette étape [1], [2] et [3]. Ce réenrobage permet d'obtenir une structure coeur/coquille dont les effets sont principalement :
- une augmentation de la photostabilité due à la présence de la matrice de silice qui joue un rôle de barrière,
- une exaltation de la luminescence par le regroupement de plusieurs molécules fluorescentes par nanoparticule, et
- une compatibilité accrue de la nanoparticule avec différents milieux notamment biologiques. Cette propriété est principalement due à la forte réactivité de surface de la silice.

De telles nanoparticules de silice encapsulant des molécules fluorescentes peuvent être utilisées dans de nombreux domaines comme les traceurs en biologie ou la lutte contre la contrefaçon.

L'état de la technique décrit déjà des nanoparticules de silice associées à des lanthanides. Toutefois, la plupart du travail décrit dans la littérature associant nanoparticules de silice et lanthanides concerne des composés inorganiques que sont les oxydes de lanthanides. Le plus gros désavantage de ces systèmes est la haute énergie nécessaire pour sensibiliser l'émission de la luminescence.

L'incorporation des lanthanides dans des molécules organiques adaptées permet d'exciter l'émission luminescente à des énergies plus faibles (UV-vis) en augmentant le coefficient d'absorption par l'effet d'« antenna ». Très peu d'exemples décrivent des complexes organométalliques de lanthanides incorporés dans des nanoparticules de silice et tous concernent des lanthanides qui émettent dans le visible.

La publication de Y. Chen et Z. Lu [4] décrit une nanoparticule contenant un complexe organométallique luminescent à base d'europium (Eu) servant de traceur fluorescent pour la reconnaissance de l'ADN. Cette publication décrit l'incorporation d'un complexe polyaminocarboxylate d'Eu appelée Coumarin102-DTPA-Eu dans une nanoparticule de polyaminocarboxylate et non dans une particule de silice. Le matériau polyaminocarboxylate limite par rapport à la silice (ou au polysiloxane) les possibilités de fonctionnalisation de surface pour l'interface avec le vivant dans le cas des traceurs pour la biologie ou avec le matériau à marquer pour l'application marqueur anti-contrefaçon.

D'autres publications décrivent l'incorporation de complexes organométalliques dans des nanoparticules de latex d'un diamètre d'environ 107 nm [5] et [6]. Dans ces publications et dans deux autres références, l'incorporation de complexes organométalliques à base de APS-BHHVT-Eu³⁺ dans une nanoparticule de silice est décrite [5], [7] et [8]. L'incorporation de complexes dans des billes de zirconium pour la réalisation de traceurs pour la biologie a également été publiée [9]. H. Hakala et al. [10] décrit l'incorporation d'un complexe d'europium (thiénylpyridine et β-diketon) dans des billes de polystyrène.

Une publication de S. Santra et al. [11] décrit une méthode de synthèse par voie sol-gel en microémulsion de particules de polysiloxane contenant un ligand complexant le Gd³⁺ pour la synthèse de traceur biologique fluorescent. La fonction fluorescente est obtenue grâce à l'incorporation de Ru(bpy) qui correspond au tris(2,2'-bipyridyl) dichlororuthénium(II) hexahydrate. Ces nanoparticules ayant à la fois une propriété de luminescence due au Ru(bpy) et magnétique due à la présence de Gd³⁺ : la fonction de luminescence et la fonction magnétique sont donc introduites par deux molécules différentes. Il convient de souligner que la molécule contenant le Gd est liée chimiquement au polysiloxane lorsque la bille est synthétisée. En effet, lors de la synthèse sol-gel, cette molécule portant l'ion lanthanide est introduite comme précurseur. Lors de la réaction sol-gel, des ponts siloxane sont créés avec le précurseur de silice (le TEOS pour « tétraéthylorthosilicate ») de façon à insérer la molécule par liaison covalente dans la matrice de silice.

Quelques exemples de nanobilles de silice incorporant des complexes de lanthanides émettant dans le visible ont été décrits dans la littérature, mais aucun de ces exemples concerne des lanthanides émettant dans le proche infrarouge.

Il existe donc un réel besoin de fournir d'autres nanoparticules de silice comprenant des molécules fluorescentes et notamment des nanoparticules de silice comprenant des complexes de lanthanides capables d'émettre une fluorescence notamment dans la zone proche-infrarouge.

### EXPOSÉ DE L'INVENTION

La présente invention permet de résoudre les problèmes techniques et inconvénients listés ci-dessus. En effet, cette dernière propose, pour la première fois, l'incorporation, dans une particule de silice, d'un complexe dont le rendement de luminescence est amélioré et qui, de plus, émet dans la zone proche-infrarouge et ce avec un bon rendement de luminescence.

La présente invention utilise l'incorporation dans des particules de silice de composés organométalliques à base de terres rares. Les composés organométalliques utilisés dans l'invention ont la particularité de pouvoir complexer fortement un ion lanthanide même en solution aqueuse et de sensibiliser l'émission de fluorescence de certaines terres rares à l'aide d'un transfert d'énergie efficace. Ce type de molécule organo-lanthanide permet, d'une part, d'avoir la luminescence propre de chaque ions lanthanide mais également d'avoir des bandes d'excitation (plage de longueur d'onde) déterminées par la partie organique de la molécule. Ainsi généralement les bandes d'excitation de ces molécules correspondent à des longueurs d'onde plus élevées que pour les oxydes de terre rare. Par ailleurs, une fois l'énergie d'excitation absorbée par la partie organique de la molécule, la structure de celle-ci permet un transfert d'énergie favorable vers l'ion lanthanide, en limitant les désexcitations non radiatives. La désexcitation de l'ion lanthanide se fait par émission de photon. Le spectre de fluorescence est ainsi caractéristique de l'ion lanthanide choisi.

La présente invention concerne, plus particulièrement, une particule de silice comprenant au moins un complexe d'au moins un lanthanide et d'au moins un ligand de formule (A) : 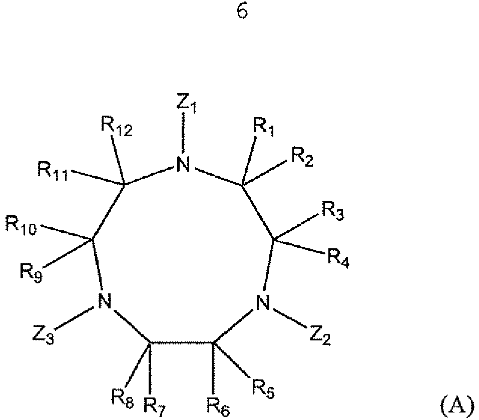 dans laquelle
- Z₁, Z₂ et Z₃, identiques ou différents, représentent chacun un groupement portant un atome porteur d'un doublet libre et/ou d'une charge négative,
- R₁, R₂, R₃, R₄, R₅, R₆, R₇, R₈, R₉, R₁₀, R₁₁ et R₁₂, identiques ou différents, représentent chacun un hydrogène, un radical alkyle éventuellement substitué, un radical aryle éventuellement substitué, un halogène, un groupe -OR₁₃ ou un groupe -SR₁₃, avec R₁₃ représentant H, un groupe alkyle éventuellement substitué ou un groupe aryle éventuellement substitué ladite formule (A) étant telle que définie dans la revendication 1.

Dans le cadre de la présente invention, le lanthanide en complexe avec le ligand de formule (A) tel que précédemment défini est choisi dans le groupe constitué par le cérium (Ce), le praséodyme (Pr), le néodyme (Nd), le prométhium (Pm), le samarium (Sm), l'europium (Eu), le gadolinium (Gd), le terbium (Tb), le dysprosium (Dy), l'holmium (Ho), l'erbium (Er), le thulium (Tm), l'ytterbium (Yb) et le lutécium (Lu). Avantageusement, le lanthanide en complexe avec le ligand de formule (A) tel que précédemment défini est choisi dans le groupe constitué par le cérium (Ce), le néodyme (Nd), l'europium (Eu), le gadolinium (Gd), le terbium (Tb), l'erbium (Er) et l'ytterbium (Yb). Ledit lanthanide se trouve, dans le complexe avec le ligand de formule (A), à un degré d'oxydation trois.

Par « radical alkyle », on entend dans le cadre de la présente invention, un groupe alkyle linéaire, ramifié ou cyclique, éventuellement substitué, de 1 à 20 atomes de carbone, notamment de 1 à 10 atomes de carbone, en particulier, de 1 à 8 atomes de carbone, tout particulièrement, de 1 à 6 atomes de carbone.

Par « radical aryle », on entend, dans le cadre de la présente invention, un groupe aromatique mono- ou polycyclique, éventuellement substitué, ayant de 6 à 20 atomes de carbone, notamment de 6 à 14 atomes de carbone, en particulier, de 6 à 8 atomes de carbone.

Par « éventuellement substitué », on entend, dans le cadre de la présente invention, un radical substitué par un ou plusieurs groupes choisis parmi : un groupe alkyle, un groupe alcoxy, un halogène, un hydroxy, un cyano, un trifluorométhyle ou un nitro.

Par « groupe alcoxy », on entend, dans le cadre de la présente invention, un atome d'oxygène substitué par un alkyle tel que précédemment défini.

Par « halogène », on entend, dans le cadre de la présente invention, un fluor, chlore, brome ou iode.

Le groupement portant un atome porteur d'un doublet libre d'électrons et/ou d'une charge négative mis en oeuvre dans le cadre de la présente invention est un groupement impliqué dans la complexation des ions métalliques et notamment des ions lanthanides.

Avantageusement, ledit groupement portant un atome porteur d'un doublet libre d'électrons et/ou d'une charge négative porte au moins un atome choisi parmi un atome d'oxygène, un atome d'azote, un atome de phosphore, un atome de soufre et un atome de carbone. Ces atomes peuvent être compris dans des groupes fonctionnels tels qu'une fonction hydroxyle, une fonction ester, une fonction acide carboxylique, une fonction amine (primaire, secondaire ou tertiaire), une fonction amide, une fonction oxime, une fonction isocyanate, une fonction iso-nitrile, une fonction hydrazine, une fonction hydrazone, une fonction imine ou une fonction phosphine.

En particulier, ledit groupement portant un atome porteur d'un doublet libre d'électrons et/ou d'une charge négative comprend, en plus d'au moins une des fonctions pré-citées, au moins un atome d'azote porteur d'un doublet libre d'électrons, inclus dans un cycle saturé, insaturé ou aromatique. Ledit cycle comprend avantageusement 3 à 8 atomes de carbone.

Dans une première variante, au moins un groupement portant un atome porteur d'un doublet libre d'électrons et/ou d'une charge négative utilisable dans le cadre de la présente invention répond à la formule (B) suivante : 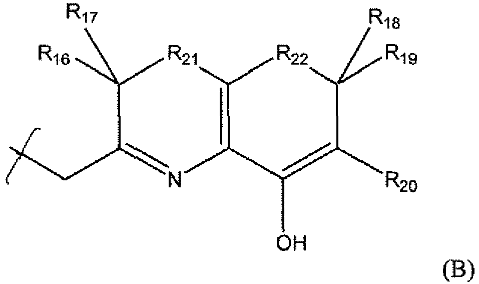 dans laquelle
- R₂₁ représente une liaison simple ou R₂₁ représente un radical =CR₂₃-, R₁₇ étant alors absent ;
- R₂₂ représente une liaison simple ou R₂₂ représente un radical -CR₂₃=, R₁₉ étant alors absent ;
- R₁₆, R₁₇, R₁₈, R₁₉, R₂₀ et R₂₃, identiques ou différents, représentent un hydrogène, un radical alkyle éventuellement substitué, un radical aryle éventuellement substitué, un halogène, un radical -SO₃H, un radical -SO₃⁻, un groupe -OR₁₃ ou un groupe -SR₁₃, avec R₁₃ représentant H, un groupe alkyle éventuellement substitué ou un groupe aryle éventuellement substitué.

Dans cette variante, des groupements particulièrement avantageux sont :
- le groupement (B₁) de formule (B) dans lequel R₂₂ représente un radical -C(SO₃⁻)= et R₁₆, R₁₇, R₁₈, et R₂₀ étant tels que précédemment définis ;
- le groupement (B₂) de formule (B) dans lequel R₁₆ = R₁₈ = R₂₀ = H ; R₂₁ = un radical =CH- et R₂₂ = un radical -CH=, R₁₇ et R₁₉ étant absents ;
- le groupement (B₃) de formule (B) dans lequel R₁₆ = R₁₈ = R₂₀ = H ; R₂₁ = un radical =CH- et R₂₂ = un radical -C(SO₃⁻)=, R₁₇ et R₁₉ étant absents.

Dans une seconde variante, au moins un groupement portant un atome porteur d'un doublet libre d'électrons et/ou d'une charge négative utilisable dans le cadre de la présente invention est choisi dans le groupe constitué par les groupements de formules (C), (D), (E), (F) et (H) suivantes : 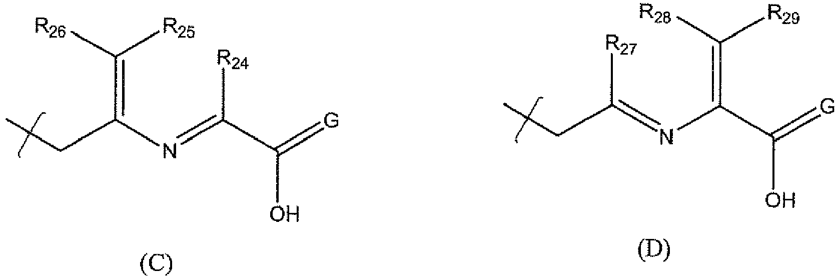 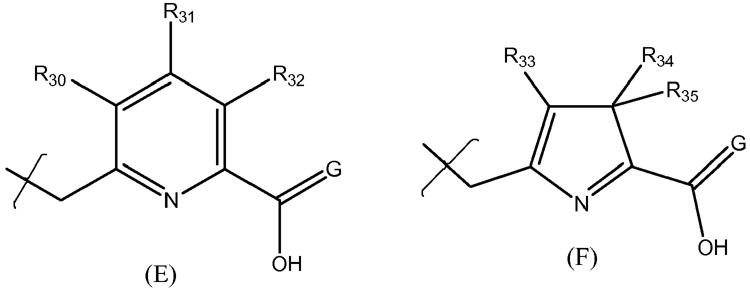 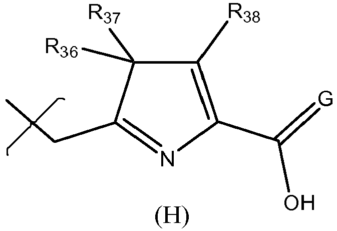 dans lesquelles
- G représente un O, N, P, S ou un C substitué indépendamment par un hydrogène, un radical alkyle éventuellement substitué ou un radical aryle éventuellement substitué,
- les radicaux R₂₄, R₂₅, R₂₆, R₂₇, R₂₈, R₂₉, R₃₀, R₃₁, R₃₂, R₃₃, R₃₄, R₃₅, R₃₆, R₃₇ et R₃₈, identiques ou différents, représentent un hydrogène, un radical alkyle éventuellement substitué, un radical aryle éventuellement substitué, un halogène, un radical -SO₃H, un radical -SO₃⁻, un groupe -OR₁₃ ou un groupe -SR₁₃, avec R₁₃ représentant H, un groupe alkyle éventuellement substitué ou un groupe aryle éventuellement substitué.

Avantageusement, les radicaux R₂₄ et R₂₅ et les radicaux R₂₇ et R₂₈ sont, deux à deux, des radicaux alkyle ou aryle éventuellement substitués pontants. De plus, G représente, de façon avantageuse, un oxygène.

L'homme du métier connaît différents procédés de préparation de ligands de formule (A) et de complexes comprenant au moins un lanthanide et au moins un ligand de formule (A) susceptibles d'être mis en oeuvre dans le cadre de la présente invention. A titre d'exemple, peuvent être cités les procédés de préparation tels que décrits dans la demande internationale WO 2007/083036-A1 [12], l'article de Cross et Sammes, 2003 [13] et l'article de Gateau et al., 2003 [14].

Les groupements Z₁, Z₂ et Z₃ peuvent indépendamment les uns des autres être choisis dans l'un quelconque des groupes ou variantes ci-dessus.

Les ligands de formule (A) mis en oeuvre dans les particules de silice de la présente invention sont avantageusement des ligands dans lesquels les groupements Z₁, Z₂ et Z₃ sont identiques. Ainsi, des ligands particulièrement préférés dans le cadre de la présente invention sont :
- le ligand dans lequel Z₁ = Z₂ = Z₃ = B₂ ci-après désigné par H₃thqtcn ;
- le ligand dans lequel Z₁ = Z₂ = Z₃ = B₃ ci-après désigné par H₃thqtcn-SO₃ ;
- le ligand dans lequel Z₁ = Z₂ = Z₃ = -CH₂-C₅H₃N-COOH ci-après désigné par H₃tpatcn.

Les structures de ces trois ligands sont schématisées ci-dessous :

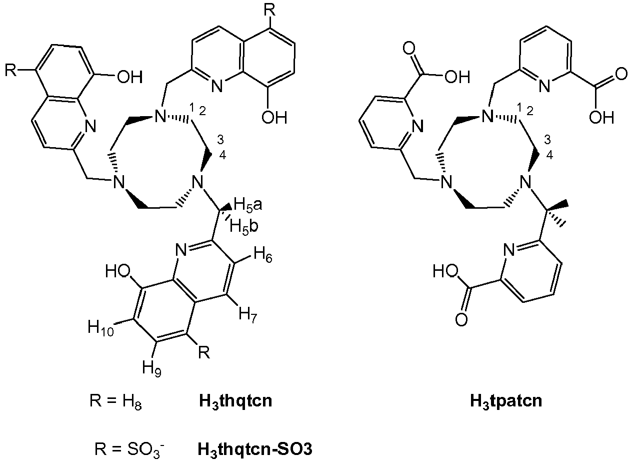

Le complexe d'au moins un lanthanide et d'au moins un ligand de formule (A) mis en oeuvre dans le cadre de la présente invention se trouve sous forme de complexe de coordination de formule générale (I)

[Ln(L) (H₂O)ₙ] (I)

dans laquelle Ln représente un lanthanide tel que précédemment défini, L est un ligand de formule (A) tel que précédemment défini et n est un entier variant de 0 à 6. Avantageusement, n est égal à 1.

Avantageusement, les particules de silice mises en oeuvre dans la présente invention sont des particules de tailles nanométrique à micrométrique. Ainsi, ces particules ont des dimensions caractéristiques comprises entre 1 nm et 200 µm, notamment entre 2 nm et 30 µm et, plus précisément, entre 2 nm et 1 µm.

Les particules de silice selon la présente invention peuvent comprendre plusieurs complexes d'au moins un lanthanide et d'au moins un ligand de formule (A) tels que précédemment définis. Avantageusement, en fonction de la taille des particules de silice, ces dernières peuvent comprendre de 1 à 10 complexes d'au moins un lanthanide et d'au moins un ligand de formule (A) tels que précédemment définis. Lorsque plusieurs complexes sont compris dans une particule de silice selon la présente invention, les ligands compris dans ces complexes peuvent être identiques ou différents, tout comme les lanthanides compris dans ces complexes. Ainsi, on peut envisager, dans le cadre de la présente invention, des particules de silice comprenant plusieurs complexes d'un même ligand avec un même lanthanide, d'un même ligand avec différents lanthanides, de différents ligands avec un même lanthanide ou de différents ligands avec différents lanthanides.

Dans une première alternative, le complexe d'au moins un lanthanide et d'au moins un ligand de formule (A) tels que précédemment définis que présente la particule de silice est encapsulé dans cette dernière. La particule de silice utilisée peut notamment être une bille de silice poreuse ou une particule de silice préparée en présence dudit complexe.

Dans cette alternative, la particule de silice comprenant un complexe d'au moins un lanthanide et d'au moins un ligand de formule (A) tels que précédemment définis, encapsulé dans cette dernière peut, en outre, être fonctionnalisée.

Par « fonctionnalisée », on entend dans le cadre de la présente invention une particule de silice sur laquelle est greffée, avantageusement par liaison covalente, au moins une molécule portant une fonction chimique spécifique, ladite fonction chimique allant des amines aux carboxyles en passant par les thiols [15], [16] ou [17].

La fonctionnalisation de particules de silice est bien connue dans l'état de l'art. La technique communément mise en oeuvre pour cette fonctionnalisation consiste à utiliser la réactivité de surface de la silice pour faire réagir les groupements Si-OH de l'oxyde de surface avec une fonction de la molécule à greffer et notamment une fonction chlorosilane. L'autre extrémité de la molécule à greffer contient la fonction chimique spécifique.

Cette alternative permet non seulement de protéger les complexes d'au moins un lanthanide et d'au moins un ligand de formule (A) du milieu environnant mais aussi de pouvoir diluer lesdits complexes dans n'importe quel solvant, hydrophile comme hydrophobe, puisque la silice est fonctionnalisable à volonté. Enfin, cette fonctionnalisation est particulièrement intéressante lorsque les nanoparticules objet de l'invention sont utilisées en biologie. Cette fonctionnalisation peut par exemple contenir des séquences d'ADN pour la reconnaissance génomique, des protéines pour la protéomique, des fonctions amine pour la solubilisation dans un tampon biologique, etc.... Grâce à cette fonctionnalisation, la surface des particules de silice selon la présente invention peut aussi être rendue biocompatible avec différentes enzymes.

La présente invention concerne également un procédé de préparation d'une particule de silice comprenant au moins un complexe d'au moins un lanthanide et d'au moins un ligand de formule (A) telle que précédemment définie et, plus particulièrement, l'alternative correspondant à une nanoparticule de silice dans laquelle est encapsulé un complexe d'au moins un lanthanide et d'au moins un ligand de formule (A), ladite particule de silice pouvant éventuellement être fonctionnalisée. Ledit procédé comprend les étapes consistant à :
a) encapsuler, dans une particule de silice, au moins un complexe comprenant au moins un lanthanide et au moins un ligand de formule (A) tel que précédemment défini et
b) éventuellement fonctionnaliser ladite particule de silice obtenue à l'étape (a).

Dans une première forme de mise en oeuvre de ce procédé, l'étape (a) consiste à :
c) utiliser une particule de silice sur laquelle est greffé au moins un complexe comprenant au moins un lanthanide et au moins un ligand de formule (A) susceptible d'être obtenue par le procédé tel que défini ci-après (étape (a') et éventuellement étape (b') définies ci-après), puis
d) enrober ladite particule par une couche de silice.

Dans une seconde forme de mise en oeuvre de ce procédé, l'étape (a) consiste à :
e) mettre en contact une particule de silice poreuse avec au moins un ligand de formule (A) tel que précédemment défini éventuellement complexé avec au moins un lanthanide tel que précédemment défini,
f) éventuellement mettre en contact la particule de silice obtenue à l'étape (e) avec au moins un lanthanide tel que précédemment défini,
g) éventuellement, enrober la particule obtenue à l'étape (f) par une couche de silice.

Dans cette seconde forme de mise en oeuvre, deux cas sont envisageables. Le premier cas correspond au cas où un complexe d'au moins un lanthanide avec au moins un ligand de formule (A) est utilisé à l'étape (e), l'étape (f) est alors inutile.

Pour le second cas, si seul le ligand de formule (A) (i.e. en absence d'au moins un lanthanide) est utilisé lors de l'étape (e), l'étape (f) est nécessaire. Dans ce cas, le (ou les) lanthanide (s) mis en oeuvre migre(nt) jusqu'au(x) ligand(s) via les pores de la particule de silice poreuse afin que le(s) complexe(s) d'organo-lanthanides puisse(nt) être formé(s). L'étape (f) consiste à remplacer l'ion autre qu'un lanthanide en complexe avec le ligand de formule (A) par un lanthanide, ledit ion étant généralement un ion Na⁺. Avantageusement, ledit remplacement est effectué en modulant le pH du milieu réactionnel dans lequel est effectué l'étape (f). Cette modulation peut être un abaissement ou un accroissement du pH en fonction du (ou des) ligand(s) utilisé(s). Le milieu réactionnel mis en oeuvre lors de l'étape (f) est avantageusement un milieu aqueux.

Dans une troisième forme de mise en oeuvre de ce procédé, l'étape (a) consiste à :
h) mettre en contact au moins un complexe comprenant au moins un lanthanide et au moins un ligand de formule (A) tel que précédemment défini avec au moins un précurseur de silice dans des conditions permettant d'obtenir une particule de silice,
i) éventuellement, enrober ladite particule obtenue à l'étape (h) par une couche de silice.

Lors des étapes (c), (e), (f) et (h), un mélange de différents lanthanides et/ou de différents ligands de formule (A) peuvent être utilisés.

Les étapes (d), (g), (h) et (i) sont des techniques bien connues de l'homme du métier de fabrication de particules de silice ou de fabrication de matériaux revêtus de silice, telles que les méthodes sol-gel et notamment la méthode dite de Ströber [18]. Ces étapes peuvent consister en la formation d'une micro-émulsion eau dans huile contenant des précurseurs de silice dans laquelle va avoir lieu la croissance de la couche de silice. Lors de l'étape (h) précédemment définie, les complexes de lanthanides étant mis en solution dans l'eau vont ainsi migrer à l'intérieur des précurseurs de silice et se faire piéger dans la matrice de silice en construction. A titre de précurseurs de silice, on peut citer le TEOS, le TMOS (pour « tétraméthylorthosilicate »), l'APTES (pour « aminopropyltriéthoxysilane ») et l'APTMS (pour « aminopropyltriméthoxysilane »).

Dans une seconde alternative, le complexe d'au moins un lanthanide et d'au moins un ligand de formule (A) tels que précédemment définis que présente la particule de silice se trouve en surface de ladite particule de silice. Ledit complexe est donc greffé à la surface de la particule de silice.

Ce greffage met avantageusement en oeuvre un groupement réactif en surface de la particule de silice et un groupement réactif porté par le complexe d'au moins un lanthanide et d'au moins un ligand de formule (A). Le groupement réactif porté par le complexe peut être porté par les radicaux R_{1 à 12} ou Z_{1 à 3} du ligand de formule (A). Le groupement réactif en surface de la particule de silice peut être soit naturellement présent à la surface de la particule de silice (greffage direct), soit apporté sur cette dernière notamment par fonctionnalisation (greffage indirect). Ce greffage implique avantageusement une liaison covalente entre les deux groupements réactifs. Dans cette variante, la particule de silice utilisée peut être une bille de silice non poreuse.

La présente invention concerne donc un procédé de préparation d'une particule de silice comprenant au moins un complexe d'au moins un lanthanide et d'au moins un ligand de formule (A) telle que précédemment définie et, plus particulièrement, l'alternative correspondant à une nanoparticule de silice sur laquelle est greffé un complexe d'au moins un lanthanide et d'au moins un ligand de formule (A). Ce procédé comprend les étapes suivantes :
a') à greffer, de façon directe ou indirecte, sur une particule de silice au moins un ligand de formule (A) éventuellement complexé avec au moins un lanthanide,
b') éventuellement mettre en contact la particule de silice greffée obtenue à l'étape (a') avec au moins un lanthanide.

Avantageusement, si l'étape (a') est mise en oeuvre en utilisant un complexe d'au moins un lanthanide avec au moins un ligand de formule (A), l'étape (b') est inutile. Par contre, si seul le ligand de formule (A) (i.e. en absence d'au moins un lanthanide) est utilisé lors de l'étape (a'), l'étape (b') est nécessaire. Cette dernière consiste à remplacer l'ion autre qu'un lanthanide en complexe avec le ligand de formule (A) par un lanthanide, ledit ion étant généralement un ion Na⁺. Avantageusement, ledit remplacement est effectué en modulant le pH du milieu réactionnel dans lequel est effectué l'étape (b'). Cette modulation peut être un abaissement ou un accroissement du pH en fonction du (ou des) ligand(s) utilisé(s). Le milieu réactionnel mis en oeuvre lors de l'étape (b') est avantageusement un milieu aqueux. A l'étape (b'), un mélange de différents lanthanides peut être utilisé et ce dans une stoechiométrie définie afin de constituer un code utilisable dans les différentes applications des particules de silice selon la présente invention. De plus, une fois l'ion lanthanide complexé au ligand de formule (A), il est extrêmement difficile de le déloger du complexe même en solution aqueuse, ce qui rend le complexe très stable.

Les ligands de formule (A) et notamment de formule (B) mis en oeuvre dans le cadre de la présente invention présentent de multiples intérêts et avantages qui sont :
- la possibilité d'incorporer toute la série des ions lanthanides sur le même type de molécule et ainsi d'avoir accès à différentes longueurs d'onde d'émission,
- une absorption vers 390 nm, ce qui est beaucoup plus haut que dans le cas des oxydes. Cet avantage permet d'avoir la fluorescence de l'ion lanthanide avec une excitation relativement haute en longueur d'onde,
- un même comportement chimique quel que soit l'ion lanthanide avec lequel elle se complexe. De ce fait, un mélange de plusieurs molécules avec des ions lanthanides sera homogène. Ceci permet de fabriquer des codes avec une dispersion homogène des molécules lors de la synthèse des particules de silice. La répartition du code est alors identique dans chaque particule de silice.

De plus, les complexes comprenant un lanthanide et au moins un ligand de formule (A) et avantageusement un ligand de formule (B) présentent des propriétés photophysiques en solution intéressantes : de forts rendements quantiques de luminescence, une solubilité et une stabilité dans l'eau élevées. En effet, les rendements quantiques de luminescence obtenus sont parmi les plus élevés jusqu'à présent décrits dans la technique. En outre, ces complexes associent, pour la première fois, de tels rendements quantiques de luminescence à une stabilité dans l'eau très élevée.

Enfin, les propriétés photophysiques telles que décrites sont conservées après l'inclusion dans de la silice. De tels complexes permettent donc d'obtenir des particules de silice incorporant de tels complexes de lanthanides avec une émission dans le proche InfraRouge. Ces systèmes sont donc particulièrement intéressants pour des applications en biologie et dans les dispositifs d'imagerie. En effet, les particules de silice selon la présente invention contiennent un code optique pouvant servir à la réalisation de traceurs pour la biologie ou de traceurs pour le marquage anti-contrefaçon. Ainsi, la présente invention concerne l'utilisation d'une particule de silice selon la présente invention ou d'une particule de silice susceptible d'être préparée par un procédé de préparation selon la présente invention en tant que traceurs pour la biologie ou en tant que traceurs pour le marquage anti-contrefaçon.

L'utilisation de complexe contenant au moins un ligand de formule (A) avec un ion Yb, Er ou Nd permet d'avoir une luminescence dans l'infrarouge. Celle-ci est très intéressante pour l'application dans le domaine biomédical et dans le domaine de l'anti-contrefaçon car, dans ce cas, il y a un grand gap en longueur d'onde entre l'excitation et l'émission et que cette dernière se trouve préférentiellement en dehors du domaine visible.

De plus, l'utilisation de l'ion Gd dans les complexes mis en oeuvre dans le cadre de la présente invention permet d'avoir, en plus des propriétés de luminescence, une propriété magnétique. Cela permet d'avoir pour la particule de silice à la fois des propriétés de luminescence (code optique) et magnétique. Cette propriété supplémentaire peut servir, dans le cas d'une utilisation comme traceur pour lutter contre la contrefaçon, de clef de détection ou d'un paramètre supplémentaire de codage. En ce qui concerne la lutte anti-contrefaçon, l'utilisation de particules de silice fonctionnalisées ou non selon la présente invention permet d'envisager d'introduire de telles particules dans différents solvants ou polymères choisis en fonction des propriétés des particules. On peut envisager d'introduire de telles particules fonctionnalisées ou non dans un polymère tel qu'un polymère thermodurcissable du type vernis ou autre. Le vernis ainsi obtenu peut être déposé ou enduit sur n'importe quel objet et notamment sur des tissus ou sur des substrats rigides (matériaux polymères, métalliques, oxydes, etc...) naturels ou synthétiques. Les particules de silice fonctionnalisées ou non objet de la présente invention introduites dans un polymère à enduire sur tout type de supports permettent, grâce à leurs propriétés, de conférer des propriétés de luminescence ou magnétiques au matériau enduit.

Pour l'application comme traceur en biologie, il est généralement nécessaire d'avoir une signature optique simple et une signature magnétique. Dans ce cas, il est possible d'incorporer dans la particule de silice à la fois un complexe avec un ligand de formule (A) avec un ion Gd (détection par imagerie par résonance magnétique, IRM) et un autre complexe avec un ligand de formule (A) avec une autre terre rare tel que le Tb ou l'Eu (émission dans le visible) ou tel que Yb ou Nd (émission dans l'infrarouge).

La présente invention décrit également certains des complexes mis en oeuvre dans les particules de silice selon l'invention.

En effet, l'assemblage d'unités 8-hydroxyquinolinate ou d'unités proches de 8-hydroxyquinolinate sur un ligand nonadenté tripodal permet d'établir un seul type de complexes de lanthanides à base de tris-hydroxyquinolinate bien définis, neutres et monomériques. En outre, alors que les 2-carboxamide-8-hydroxyquinoline tridentés ont récemment conduit à isoler des complexes de lanthanides dans différentes formes isomériques (*syn* ou *anti*), l'utilisation d'une ancre tripodale pour organiser les unités hydroxyquinolinate bidentées conduit à un seul type de complexes de lanthanides.

Ainsi, la présente invention décrit un complexe comprenant au moins un lanthanide et au moins un ligand de formule (A) 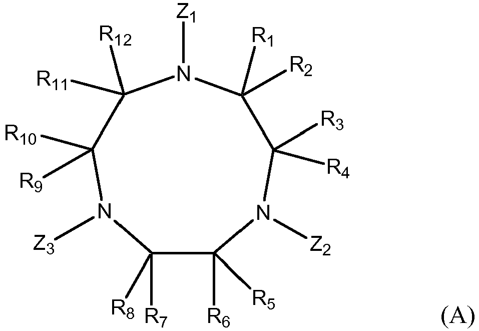 dans laquelle
- R₁, R₂, R₃, R₄, R₅, R₆, R₇, R₈, R₉, R₁₀, R₁₁ et R₁₂, identiques ou différents, représentent chacun un hydrogène, un radical alkyle éventuellement substitué, un radical aryle éventuellement substitué, un halogène, un groupe -OR₁₃ ou un groupe -SR₁₃, avec R₁₃ représentant H, un groupe alkyle éventuellement substitué ou un groupe aryle éventuellement substitué,
- Z₁, Z₂ et Z₃, identiques ou différents, représentent chacun un groupement de formule (B) suivante : 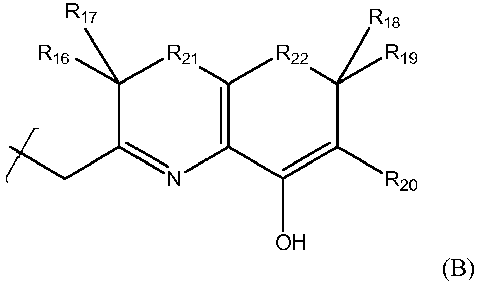 dans laquelle
- R₂₁ représente une liaison simple ou R₂₁ représente un radical =CR₂₃-, R₁₇ étant alors absent ;
- R₂₂ représente une liaison simple ou R₂₂ représente un radical -CR₂₃=, R₁₉ étant alors absent ;
- R₁₆, R₁₇, R₁₈, R₁₉, R₂₀ et R₂₃, identiques ou différents, représentent un hydrogène, un radical alkyle éventuellement substitué, un radical aryle éventuellement substitué, un halogène, un radical -SO₃H, un radical -SO₃⁻, un groupe -OR₁₃ ou un groupe -SR₁₃, avec R₁₃ représentant H, un groupe alkyle éventuellement substitué ou un groupe aryle éventuellement substitué.

La présente invention concerne également les complexes préférés tels que précédemment définis et répondant à cette définition générale.

La présente invention décrit également certains des ligands mis en oeuvre dans le cadre des nanoparticules de silice selon l'invention. Ainsi, la présente invention décrit un ligand de formule (A) 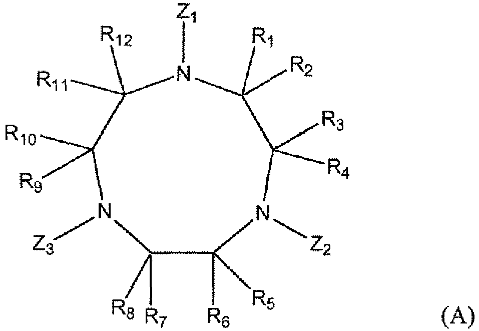 dans laquelle
- R₁, R₂, R₃, R₄, R₅, R₆, R₇, R₈, R₉, R₁₀, R₁₁ et R₁₂, identiques ou différents, représentent chacun un hydrogène, un radical alkyle éventuellement substitué, un radical aryle éventuellement substitué, un halogène, un groupe -OR₁₃ ou un groupe -SR₁₃, avec R₁₃ représentant H, un groupe alkyle éventuellement substitué ou un groupe aryle éventuellement substitué,
- Z₁, Z₂ et Z₃, identiques ou différents, représentent chacun un groupement de formule (C) suivante : 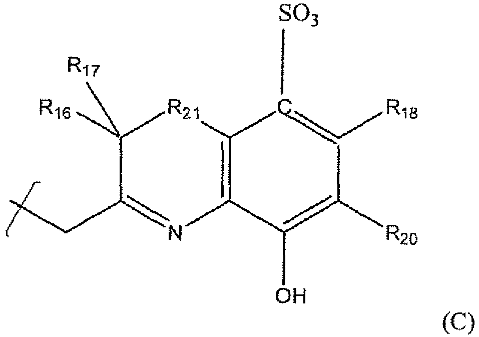 dans laquelle
- R₂₁ représente une liaison simple ou R₂₁ représente un radical =CR₂₃-, R₁₇ étant alors absent ;
- R₁₆, R₁₇, R₁₈, R₂₀ et R₂₃, identiques ou différents, représentent un hydrogène, un radical alkyle éventuellement substitué, un radical aryle éventuellement substitué, un halogène, un radical -SO₃H, un radical -SO₃⁻, un groupe -OR₁₃ ou un groupe -SR₁₃, avec R₁₃ représentant H, un groupe alkyle éventuellement substitué ou un groupe aryle éventuellement substitué.

La présente invention décrit également les ligands préférés décrits dans la présente et répondant à la définition générale ci-dessus.

D'autres caractéristiques et avantages de la présente invention apparaîtront encore à l'homme du métier à la lecture des exemples ci-dessous donnés à titre illustratif et non limitatif, et faisant référence aux figures annexées.

### BRÈVE DESCRIPTION DES DESSINS

La figure 1 est une représentation ellipsoïdale du complexe 1 tel que défini dans la présente, vu de dessus (probabilité de 30%).
La figure 2 propose le polyèdre de coordination du Nd dans le complexe [Nd(thqtcn)].
La figure 3 présente le spectre ¹H RMN d'une solution Nd : thqtcn-SO₃ (1 : 1) dans une solution de D₂O à pD de 7,7 ; à 70 °C et à 400 MHz.
La figure 4 présente un cliché de microscopie électronique en transmission (TEM) de nanoparticules de silice comprenant des complexes d'organo-lanthanides selon la présente invention, dispersées dans de l'éthanol.
La figure 5 présente graphiquement la mesure du potentiel Zêta de nanoparticules de silice comprenant des complexes d'organo-lanthanides selon la présente invention.

### EXPOSÉ DÉTAILLÉ DE MODES DE RÉALISATION PARTICULIERS

### I. Synthèse et caractérisation des ligands.

### I.1. Synthèse du H₃thqtcn : 1,4,7-Tris-[2-(8-hydroxyquinolinyl)méthyl]-1,4,7-triazacyclononane.

Le ligand H₃thqtcn a été synthétisé, en 4 étapes, à partir des produits accessibles dans le commerce et selon le protocole décrit par J. P. Cross et P. G. Sammes [13] légèrement modifié, cette modification ayant entraîné une importante augmentation du rendement (11 % *vs* 4 %).

Une solution d'ester de 1,4,7-Tris-[2-(8-(2,2-diméthylpropanoyloxy)quinolinyl)methyl]-1,4,7-triazacyclononane (1,171 g, 1,37 mmol) dans du THF dégazé (30 mL) a été ajoutée à une solution dégazée de KOH dans de l'eau milliQ (10 mL, 12,35 mmol). La solution ainsi obtenue a été mélangée à température ambiante pendant 6 jours puis neutralisée (pH = 7) par addition d'une solution aqueuse de HCl 1M (∼ 6 mL). Le produit brut a été extrait avec de l'acétate d'éthyle (75 mL) et la couche organique lavée avec une solution aqueuse saturée de NaHCO₃ (5 × 15 mL), puis avec une solution aqueuse saturée de NaCl (5 × 15 mL) et finalement séchée avec du Na₂SO₄ anhydre. Après évaporation du solvant, le résidu a été trituré dans de l'éther pour obtenir du H₃thqtcn. 0,5 H₂O. 0,2 KCl en tant qu'un solide jaune pâle (0,608 g, 74 %).

**RMN-¹H** (D₂O, 400 MHz, 298 K, pD = 1.4): δ=3.55 (s, 12H, N(CH₂)₂N), 4.0 (s, 6H, N(CH₂)qui), 6.81 (d, J = 8.0 Hz, 3H, H₁₀), 7.21 (d, J = 8.0 Hz, 3H, H₈), 7.26 (t, J = 8.0 Hz, 3H, H₉), 7.44, (d, J = 8.8 Hz, 3H, H₆), 8.15 (d, J = 8.8 Hz, 3H, H₇).

**ES-MS** *m*/*z* (%): 601.3 (100) [M + H]⁺, 623.3 (7) [M + Na]⁺.

Anal. Calc. pour H₃thqtcn; C 0.5H₂O. 0.2KCl; C₃₆H₃₇N₆O_{3.5}K_{0.2}Cl_{0.2} (624.64) : C 69.22, H 5.97, N 13.45; trouvé : C 69.29, H 6.01, N 13.22%.

### I.2. Synthèse du H₆thqtcn-SO₃ : 1,4,7-Tris-[2-(5-sulfo-8-hydroxyquinolinyl)methyl]-1,4,7-triazacyclononane.

Le ligand H₃thqtcn (0,104 g, 0,17 mmol) a été couvert par une quantité minimale d'oléum (H₂SO₄/SO₃ 20%, 1,5 mL). Le mélange a été agité toute la nuit à température ambiante puis versé sur de la glace. La solution a été évaporée jusqu'à siccité puis dissoute dans de l'EtOH. Une lente évaporation de la solution à 4 °C a produit un précipité jaune d'une forme tris-protonée du ligand H₆thqtcn-SO₃. 6H₂O. 0.3H₂SO₄ (0.134 g, 92%).

**RMN ¹H** (D₂O, 400 MHz, 298 K, pD = 8.3) : δ=2.95 (s, 12H, N(CH₂)₂N), 3.85 (s, 6H, N(CH₂)qui), 6.66 (d, J = 7.6 Hz, 3H, H₁₀), 7.60 (d, J = 7.6 Hz, 3H, H₉), 7.72 (t, J = 7.6 Hz, 3H, H₇), 8.75, (d, J = 7.6 Hz, 3H, H₆).

**ES-MS** *m*/*z* (%): 641.2 (100) [M + H]⁺.

Anal. Calc. for H₆thqtcn-SO₃. 6H₂O. 0.3H₂SO₄; C₃₆H₄₈.₆N₆O₁₃.₂S₃.₃ (978.40) : C 44.23, H 4.95, N 8.60; Trouvé: C 44.07, H 4.99, N 8.63%.

La grande solubilité du ligand H₆thqtcn-SO₃ a permis la détermination de ses constantes de déprotonation par titrage potentiométrique de la forme protonée Hₓthqtcn-SO₃ du ligand avec du KOH dans du KCl à 0,1 M à 298 K. La forme entièrement protonée H₁₂thqtcn-SO₃ du ligand a 12 sites de déprotonation, 3 groupes pyridinium, 3 nitrogènes tertiaires, 3 oxygènes hydroxyle et 3 groupes sulfoniques. Les 3 sulfonates sont complètement déprotonés dans les conditions expérimentales utilisées. Les constantes de deprotonation du H₉thqtcn-SO₃³⁺ sont définies comme Kₐᵢ = [H₉₋ᵢL] ⁽¹⁻ⁱ⁾ [H]⁺ /[H₈₋ᵢL] ⁽²⁻ⁱ⁾⁺. L'analyse des courbes potentiométriques a permis la détermination précise de 6 constantes de déprotonation (pKa₈ = 2,9(2), pKa₇ = 5,34(5), pKa₆ = 8,01(8), pKa₅ = 8,78(1), pKa₄ = 8,98(4), pKa₃ = 10,25(2)), alors qu'il était possible d'uniquement obtenir la somme de pKa₁+pKa₂ = (22,51(3)).

### I.3. Synthèse du H₃tpatcn : 1,4,7-Tris-[(6-(carboxypyridin-2-yl)méthyl]-1,4,7-triazacyclononane.

Cette synthèse a été effectuée selon le protocole décrit par Gateau et al., 2003 [14].

### II. Synthèse et caractérisation des complexes de lanthanides.

### II.1. Complexe [Ln(thqtcn)] avec Ln = Nd, Er, Yb.

Une solution de Ln(OTf)₃ (Ln = Nd, Er, Yb) (0,09 mmol) dans du méthanol (4 mL) a été ajoutée à une solution de H₃thqtcn (0,09 mmol) dans du méthanol (4 mL). L'addition de 0,85 équivalent d'une solution aqueuse à 1 M de KOH a donné une solution jaune limpide qui a été réfrigérée à 4 °C toute la nuit. Le KOTf a été éliminé par filtration. La diffusion lente d'une solution de KOH (3,3 équivalents additionnels) à la solution résultante à 4 °C entraîne la formation d'un solide microcristallin jaune qui a été séparé par filtration, lavé avec du méthanol et de l'eau milliQ, et séché sous un vide secondaire pendant deux jours pour obtenir le complexe [Ln(thqtcn] (48-79%).

Anal. Calc. [Nd(thqtcn)], C₃₆H₃₃N₆O₃Nd: C 58.28, H 4.48, N 11.33; Trouvé : C 58.89, H 4.52, N 11.14%. Anal. Calc. for [Er(thqtcn)], C₃₆H₃₃N₆O₃Er : C 56.53, H 4.35, N 10.99; Trouvé : C 56.98, H 4.22, N 10.73%. Anal. Calc. for [Yb(thqtcn)], C₃₆H₃₃N₆O₃Yb: C 56.10, H 4.32, N 10.90; Trouvé : C 55.81, H 4.06, N 10.65%.

Les analyses élémentaires de tous les complexes sont compatibles avec la présence d'espèces [Ln(thqtcn)] analytiquement pures. Ces complexes sont insolubles dans tous les solvants habituellement utilisés dans les laboratoires.

Les monocristaux de [Nd(thqtcn)] utilisables pour une diffraction de rayons X ont été obtenus par une lente diffusion d'une solution de KOH à 1mM dans une solution de méthanol à 4mM de 1:1:0,85 Nd:H₃thqtcn:KOH. Des cristaux utilisables pour une diffraction de rayons X ont également été obtenus pour le complexe [Eu(thqtcn)] (complexe 2) par extraction à partir d'acétonitrile chaud. Le complexe [Nd(thqtcn)] (complexe 1) est montré à la Figure 1. Les distances et angles sélectionnés sont présentés pour le complexe 1 dans le Tableau 1 ci-dessous.

**Tableau 1**

| | [Nd(thqtcn)] |
|---|---|
| M-O (1) | 2, 393 (3) |
| M-O (2) | 2, 409 (3) |
| M-O (3) | 2, 406 (3) |
| M-N (1) mcy | 2, 788 (4) |
| M-N (3) mcy | 2, 789 (3) |
| M-N (2) mcy | 2, 796 (4) |
| M-N(4)py | 2, 609 (4) |
| M-N (5) py | 2, 621 (4) |
| M-N (6) py | 2, 608 (4) |

Dans les deux complexes, l'ion métallique est coordiné 9 fois par 9 atomes donneurs du ligand : 3 nitrogènes du cycle 1,4,7-triazacyclononane, 3 nitrogènes et 3 oxygènes des unités hydroxyquinoléine. Les bras pendants hydroxyquinoléine lient le métal dans un mode hélicoïdal et les deux énantiomères L et D sont trouvés dans la structure cristallographique du complexe de Nd entraînant un groupe d'espace centrosymétrique P2(1)/c. La structure cristallographique du complexe de Eu présente uniquement l'énantiomère L résultant en un groupe d'espace chiral (R32). Des structures analogues ont déjà été observées pour le complexe [Ln(tpatcn)] nonacoordonné avec tpatcnH₃ = 1,4,7-tris[(6-carboxypyridin-2-yl)methyl]-1,4,7-triazacyclononane et Ln = Nd, Eu, Gd ou Lu [18].

Le polyèdre de coordination de [Nd(thqtcn)] peut être décrit comme un prisme trigonal, tricapé, légèrement distordu avec une pseudo-symétrie C₃ (Figure 2). Le complexe [Eu(thqtcn)] adopte également une géométrie prismatique, trigonale, tricapée mais présente un axe cristallographique C₃. Dans les deux complexes, une face triangulaire est formée par les 3 nitrogènes du macrocycle 1,4,7-triazacyclononane, et une seconde par les 3 oxygènes quinolinate. Les 3 nitrogènes des groupes hydroxyquinolate occupent les positions capantes. Les faces triangulaires à base d'oxygène sont légèrement tordues autour de l'axe des faces à base de nitrogène. La valeur moyenne des angles de torsion formés par les atomes des faces rectangulaires est de 22. (2) pour Nd et de 19.2 (3) pour Eu alors qu'une distorsion légèrement supérieure à partir de la géométrie trigonale régulière a été trouvée pour les complexes [Nd(tpatcn)] (24.2(8)) et [Eu(tpatcn)] 22.0(3). Les plans définis par les deux faces triangulaires sont presque parallèles dans les deux complexes (angle entre les plans 0° pour Eu et 2° pour Nd).

### II.2. Complexe [Ln (Hₙthqtcn)]ⁿ⁺ avec Ln = Nd, Yb.

Les espèces partiellement protonées ont été préparées *in situ* en mélangeant des quantités équimolaires du ligand et du sel Ln(OTf₃) approprié dans du MeOD. Des aliquotes d'une solution à 1M de KOD dans du D₂O ont été successivement ajoutés et la formation du complexe a été suivi par RMN-¹H. L'addition de 0,85 équivalent de base est nécessaire pour avoir une complexation complète du ligand. Cependant, au-delà de 0,85 équivalent, la précipitation d'une poudre jaune est survenue.

**[Nd(Hₙthqtcn)]ⁿ⁺. RMN ¹H** (CD₃OD, 400 MHz, 25°C): δ=-1.50 (s, 1H, H_{5a/}H_{5b}), -0.12 (s, 1H, (CH₂)tcn), 5.09 (s, 1H, H_{5a/}H_{5b}), 6.68 (s, 1H, H₉), 6.83 (s, 1H, (CH₂)tcn), 6.83 (s, 1H, H₁₀), 7.47 (d, J = 8.0 Hz, 1H, H₈), 8.40 (d, J = 8.0 Hz, 1H, H₆), 8.62 (d, J = 8.0 Hz, 1H, H₇), 9.10 (s, 1H, (CH₂)tcn), 9.91 (s, 1H, (CH₂)tcn). **RMN ¹H** (CD₃OD, 400 MHz, 40°C): δ=-1.08 (s, 1H, H₅ₐ/H_{5b}), -0.01 (s, 1H, (CH₂)tcn), 5.03 (s, 1H, H₅ₐ/H_{5b}), 6.53 (s, 1H, H₉), 6.73 (s, 1H, H₁₀), 6.84 (s, 1H, (CH₂)tcn), 7.50 (d, J = 8.0 Hz, 1H, H₈), 8.41 (d, J = 8.0 Hz, 1H, H₆), 8.67 (d, J = 8.0 Hz, 1H, H₇), 8.72 (s, 1H, (CH₂)tcn), 8.43 (s, 1H, (CH₂)tcn).

**[Yb(Hₙthqtcn)]ⁿ⁺. RMN ¹H** (CD₃OD, 400 MHz, 25°C): δ=-12.11 (s, 1H, (CH₂)tcn), -4.88 (s, 1H, (CH₂)tcn), -3.70 (s, 1H, H₅ₐ/H_{5b}), 2.77 (s, 1H, (CH₂)tcn), 4.59 (s, 1H, H₅ₐ/H_{5b}), 4.59 (s, 1H, H₁₀), 7.87 (s, 1H, H₉), 8.25 (d, J = 8.0 Hz, 1H, H₈), 9.23 (s, 1H, H₆), 9.95 (s, 1H, H₇), 15.16 (s, 1H, (CH₂)tcn). **RMN ¹H** (CD₃OD, 400 MHz, 15°C): δ=-13.16 (s, 1H, (CH₂)tcn), -5.41 (s, 1H, (CH₂)tcn), -4.18 (s, 1H, H₅ₐ/H_{5b}), 3.60 (s, 1H, (CH₂)tcn), 4.47 (s, 1H, H₁₀), 5.55 (s, 1H, H₅ₐ/H_{5b}), 7.89 (s, 1H, H₉), 8.27 (d, J = 8.0 Hz, 1H, H₈), 9.25 (d, J = 8.0 Hz, 1H, H₆), 9.99 (d, J = 8.0 Hz, 1H, H₇), 15.80 (s, 1H, (CH₂)tcn).

Une lente diffusion d'éther d'isopropyle dans les solutions ci-dessus a permis d'obtenir des cristaux jaunes utilisables pour une diffraction de rayons X.

### II.3. Complexe [Ln (thqtcn-SO₃)]³⁻ avec Ln = Nd, Er, Yb.

La solubilité dans l'eau est essentielle pour une utilisation des complexes de lanthanides en tant que sondes luminescentes pour l'imagerie biomédicale. Le groupe caractéristique sulfonyle est connu pour aider à la solubilisation dans l'eau des entités hydrophobes par la formation d'espèces négativement chargées. Ainsi, H₃thqtcn-SO₃ analogue de H₃thqtcn a été préparé.

Les complexes pour les mesures de RMN ¹H et de luminescence ont été préparés *in situ* en mélangeant des quantités stoechiométriques du ligand H₆thqtcn-SO₃ et du Ln(OTf)₃ approprié. La RMN ¹H a été réalisée dans du D₂O après ajustement de la valeur du pD avec une solution de KOD. Des solutions à 1 mM des complexes de [Ln(thqtcn-SO₃)]³⁻ dans du TBS à 0,1 M (pH = 7,4) ont été utilisées pour les études de luminescence.

**[Nd(thqtcn-SO₃)]3⁻. RMN ¹H** (D₂O, 400 MHz, 25°C, pD 7.7): δ=0.46 (s, 1H, (CH₂)tcn), 0.78 (s, 1H, (CH₂)tcn), 1.68 (s, 1H, (CH₂)tcn), 4.82 (s, 1H, (CH₂)tcn), 5.46 (s, 1H, H₅ₐ/H_{5b}), 5.97 (s, 1H, H₅ₐ/H_{5b}), 6.87 (d, J = 7.0 Hz, 1H, H₁₀), 8.89 (d, J = 7.0 Hz, 1H, H₉), 9.83 (d, J = 8.0 Hz, 1H, H₆), 10.32 (d, J = 8.0 Hz, 1H, H₇). **RMN ¹H** (D₂O, 400 MHz, 70°C, pD 7.7): δ=0.62 (s, 1H, (CH₂)tcn), 1.30 (s, 1H, (CH₂)tcn), 1.75 (s, 1H, (CH₂)tcn), 4.50 (s, 1H, (CH₂)tcn), 5.16 (s, 1H, H₅ₐ/H_{5b}), 5.54 (s, 1H, H₅ₐ/H_{5b}), 6.81 (d, J = 7.0 Hz, 1H, H₁₀), 8.75 (d, J = 7.0 Hz, 1H, H₉), 9.46 (d, J = 8.0 Hz, 1H, H₆), 10.52 (d, J = 8.0 Hz, 1H, H₇).

Comme espéré, ce ligand entraîne des complexes de Ln(III) hydrosolubles aux pH physiologiques. Le spectre d'une solution Nd:thqtcn-SO₃ (1:1) dans du D₂O à 70°C et à pD = 7,7 montre la présence de 4 signaux affectés aux 12 protons du macrocycle 1,4,7-triazacyclononane (d = 0.62, 1.30, 1.75 et 4.50 ppm), 2 signaux pour les protons des 6 méthylènes des bras du ligand (d = 5.16 et 5.54 ppm) et 4 signaux correspondant aux 5 protons aromatiques de l'hydroxyquinoléine (d = 6.81, 8.75, 9.46 et 10.52 ppm) (Figure 3).

La stabilité thermodynamique et cinétique dans l'eau à un pH physiologique est une propriété cruciale pour l'application des complexes de lanthanide en tant que tags luminescents dans les systèmes biologiques. La grande solubilité dans l'eau des complexes de thqtcn-SO₃⁶⁻ a poussé les inventeurs à étudier leur stabilité pour évaluer leur potentiel d'application.

De façon notable, l'interaction entre les ions lanthanide et le ligand a été suivie par spectrophotométrie UV-visible pour un ion représentatif de taille intermédiaire qu'est le Gd en solutions aqueuses diluées, tamponnées par de l'Hepes à pH 7,4. La valeur de pGd (pM= -log[M]_{libre} à pH 7,4, [M]ₜₒₜₐₗ =1 mM et [bpatcn]ₜₒₜₐₗ= 10 mM), qui permet une comparaison simple et directe des stabilités des complexes en conditions physiologiques, trouvée pour thqtcn-SO₃⁶⁻ (19) est similaire à la valeur rapportée pour les complexes de gadolinium d'acide diéthylénétriaminopentaacétique (dtpa) (pGd = 19,6) qui sont largement reconnus comme non-toxiques. La grande stabilité à un pH physiologique et la grande stabilité cinétique du complexe de gadolinium avec le ligand thqtcn-SO₃⁶⁻ indiquent que les complexes de lanthanide avec le ligand thqtcn-SO₃⁶⁻ sont particulièrement adaptés pour des applications en tant que sondes dans l'imagerie biomédicale.

De plus, il a été démontré que, aux concentrations et pH utilisés, le complexe thqtcn-SO₃ ne se dissocie pas dans l'eau, ne contient pas de molécules d'eau coordonnées et présente une sphère de coordination interne, rigide et plutôt bien définie.

### II.4. Synthèse des complexes de lanthanides ayant pour ligand H₃tpatcn.

Cette synthèse a été effectuée selon les protocoles décrits par Gateau et al., 2003 [18].

### III. Incorporation des complexes de lanthanides dans une bille de silice.

Le protocole utilisé pour cette incorporation est le suivant :
- préparation d'une solution comprenant 1,65 mL de Triton X-100 (surfactant non ionique), de 1,6 mL d'hexanol, de 7,5 mL de cyclohexane, 80 µL de solution aqueuse du complexe de lanthanide qu'est le Eu(tpatcn) à 0,1 M, 100 µL d'ammonium aqueux (30% en masse) et 400 µL d'eau ;
- agitation de ladite solution pendant 30 min, à température ambiante ;
- ajout de 100 µL de TEOS ;
- agitation pendant 24 h, à température ambiante ;

Ce protocole consiste en la formation d'une micro-émulsion eau dans huile contenant de fait des nanoréacteurs dans lesquels va avoir lieu la croissance de la couche de silice. Les complexes de lanthanides étant mis en solution dans l'eau vont ainsi migrer à l'intérieur des nanoréacteurs et se faire piéger dans la matrice de silice en construction.

Cette synthèse permet d'obtenir des nanoparticules luminescentes, sphériques, de taille 40 nm parfaitement dispersées dans un solvant tel que l'éthanol. Le cliché TEM permet d'en témoigner (Figure 4).

### IV. Propriétés photophysiques des nanoparticules de silice comprenant des complexes de lanthanides selon l'invention.

Tous les chélates Eu^{III} et yb^{III} du ligand thqtcn-SO₃⁶⁻, aussi bien en solution qu'insérés dans la silice, présentent une luminescence NIR centrée sur le métal dans des solutions aqueuses tamponnées (pH 7,4), avec presqu'aucune émission résiduelle des ligands, ce qui indique un transfert d'énergie efficace.

Les complexes permettent un important effet "antenna" associé à des longueurs d'onde d'excitation à basse énergie pour le complexe Yb^{III}, comparé aux nanoparticules contenant des oxydes de lanthanides qui nécessitent une forte énergie d'excitation.

De plus, l'émission des chélates en solution ou insérés dans des nanoparticules de silice, présentent un spectre d'émission avec un recouvrement parfait, indiquant que la symétrie des chélates est préservée dans les nanoparticules. Enfin, il n'y a pas d'interaction entre l'ion lanthanide et le réseau de silice.

Les durées de vie observées de 1,08 et 1,23 ms pour le complexe [Eu(tpatcn)] en solution dans l'eau ou encapsulé dans la silice, respectivement, sont comparables aux valeurs mesurées pour les podates, indiquant que la silice fournit une meilleure protection pour l'ion Ln^{III} vis-à-vis de son environnement et des processus de désactivation non-radiative.

Les durées de vie mesurées en solution dans l'eau pour le chélate [Yb(thqtcn-SO₃)] présentent des résultats similaires avec 2,05 et 4,17 ms, respectivement en solution et encapsulé. De plus, l'augmentation est deux fois supérieure comparée aux durées de vie du complexe [Eu(tpatcn)] du fait que l'ion Yb^{III} est bien plus sensible au quenching de la luminescence par des vibrations à haute énergie.

Les rendements quantiques des chélates de Eu^{III} et yb^{III} ont été mesurés à pH 7,4 et à température ambiante. Dans les deux cas, la luminescence visible et NIR de chélates de ln^{III} 1:1 est suffisamment intense en solution aqueuse pour permettre la détermination des rendements quantiques. Ces chélates présentent des rendements quantiques assez grands par rapport aux données publiées dans la littérature, en particulier pour le Yb^{III} et pour les solutions aqueuses. Un rendement quantique aussi élevé que 0,11 % a été obtenu pour le chélate du yb^{III} inséré dans des nanoparticules de silice (0,14 % en solution) et 1,6 % pour le chélate du Eu^{III} (9,0 % en solution). En effet, il est bien connu que les ions Ln^{III} émettant dans le proche InfraRouge, en raison de leur petite bande interdite, sont très sensibles au photoblanchîment par les oscillateurs immédiats, tels que O-H, N-H, ou même C-H. Un rendement quantique de 0,11 % est un des rendements quantiques les plus élevés observés en solution aqueuse.

Ces rendements quantiques de luminescence des chélates en solution et insérés dans des nanoparticules de silice sont plus proches en tenant compte de l'absorption de la silice. En calculant et en considérant qu'aucune autre voie de désactivation n'est changée entre les chélates lors des mesures de durées de vie, nous pouvons estimer que la diminution des rendements quantiques est le résultat de l'absorption de la silice. En fait, la silice pure a des longueurs d'ondes d'absorption et d'excitation comprises entre 200 to 500 nm. Comme les mesures du rendement quantique résultant d'une méthode absolue avec une sphère d'intégration, l'absorption des photons par les nanoparticules n'est pas corrélée à l'émission des photons par l'ion lanthanide. Une partie de l'énergie d'excitation est absorbée par la silice et libérée par des procédés de désactivation non radiative sans transfert aux complexes.

La contribution de cette absorption peut être estimée en comparant les complexes de Eu^{III} et de Yb^{III}. Dans le cas des nanoparticules de Eu^{III}, la longueur d'onde d'excitation est de 270 nm résultant en une absorption d'environ 80 % de l'énergie par la silice alors que cette dernière est seulement proche de 20 % pour le complexe de Yb^{III} qui est plus sensible aux processus de désactivation. L'explication est qu'à 300 nm (excitation des nanoparticules de Eu^{III}), l'absorption de la silice pure est bien plus importante qu'à 390 nm (excitation des nanoparticules de Yb^{III}).

Il a donc été démontré que la silice agit comme un hôte efficace pour les chélates de Ln^{III} qui ont des durées de vie plus longues qu'en solution. Ces mesures de luminescence indiquent qu'il n'y a pas d'effet de quenching observable et aucune interaction entre le réseau de silice et les chélates de lanthanides dans la nanoparticule. De plus, l'insertion des chélates dans la silice n'a quasiment aucune influence sur les propriétés photophysiques des chélates (durée de vie, rendements quantiques et spectre de luminescence).

### V. Coquille de silice protectrice et fonctionnalisation de la surface de la silice.

Le protocole suivant a été utilisé pour obtenir une nanoparticule de silice comprenant au moins un complexe de lanthanide et à la surface de laquelle une fonction amine est greffée :
- préparation d'une solution comprenant 1,65 mL de Triton X-100 (surfactant non ionique), de 1,6 mL d'hexanol, de 7,5 mL de cyclohexane, 80 µL de solution aqueuse du complexe de lanthanide qu'est le Eu(tpatcn) à 0,1 M, 100 µL d'ammonium aqueux (30% en masse) et 400 µL d'eau ;
- agitation de ladite solution pendant 30 min, à température ambiante ;
- ajout de 100 µL de TEOS ;
- agitation pendant 24 h, à température ambiante ;
- ajout de 15 µL TEOS et de 15 µL de APTES utilisé pour obtenir une fonction amine greffée, à température ambiante ;
- agitation pendant 24 h, à température ambiante ;

Une mesure du potentiel Zêta des nanoparticules ainsi obtenues permet de caractériser la modification de surface. Les courbes présentées à la Figure 5 montrent une modification de la charge de surface et donc une fonctionnalisation de la surface, une fonction amine hydrophile ayant bien été greffée en surface de la nanoparticule.

Il convient de remarquer que l'ajout de TEOS permet de réaliser une coquille de silice autour de la matrice initialement créée. Cette coquille permet de retrouver un état neutre en surface de la silice. Effectivement, une mesure de potentiel Zêta montre que l'incorporation de la molécule complexée ne se fait pas uniquement à l'intérieur de la matrice de silice mais qu'il y en a aussi en surface. En faisant croître cette nouvelle couche de Silice, on s'affranchit de la présence de complexes de lanthanides en surface et retrouve de fait l'état de surface de la silice neutre. Le complexe de lanthanides n'est donc plus dès lors en contact avec le milieu extérieur.

### REFERENCES

[1] H. Ow, Larson DR, Srivastava M et al, "Bright and stable core-shell fluorescent silica nanoparticles", NanoLetters 2005 ; Vol. 5, No. 1, 113-117,
[2] N.A.M Verhaegh et A. VanBlaaderen, "Dispersions of rhodamine-labeled silica spheres-synthesis, Characterization, and fluorescence confocal scanning laser microscopy" ; Langmuir ; 1994 ; Vol. 10, 1427-1438,
[3] Andrew Burns, Hooisweng Ow et Ulrich Wiesner, "Fluorescent core-shell silica nanoparticles: towards "Lab on a Particle" architectures for nanobiotechnology", Chem. Soc. Rev., 2006, 35, 1028-1042,
[4] Y. Chen et Z. Lu, "Dye sensitized luminescent europium nanoparticles and its time-resolved fluorometric assay for DNA", Analytica Chimica Acta, 587 (2007), 180-186,
[5] J. Yuan and G. Wang, "Lanthanide-based luminescence probes and time-resolved luminescence bioassays", Trends in Analytical Chemistry, 25 (2006), 490-500,
[6] H. Härmä, T. Soukka, T. Lövren, "Europium nanoparticles and time-resolved fluorescence for ultrasensitive detection of prostate-specific antigen", Clin. Chem., 47 (2001), 561-568,
[7] Z. Ye, M. Tan, G. Wang, J. Yuan, "Preparation, characterization, and time-resolved fluorometric application of silica-coated terbium(III) fluorescent nanoparticles", Anal. Chem., 76 (2004), 513-518,
[8] Z. Ye, M. Tan, G. Wang, J. Yuan, J., "Novel fluorescent europium chelate-doped silica nanoparticles: préparation, characterization and time-resolved fluorometric application", Mat. Chem., 14 (2004), 851-856,
[9] M. Tan, G. Wang, Z. Ye, J. Yuan, "Synthesis and characterization of titania-based monodisperse fluorescent europium nanoparticles for biolabeling", Journal of Luminescence, 117 (2006), 20-28,
[10] H. Hakala, V.M. Mukkala, T. Sutela and J. Hovinen, "Synthesis and properties of nanospheres copolymerised with luminescent europium(III) chelates", Org. Biomol. Chem, 4 (2006), 1383-1386,
[11] S. Santra, R. P. Bagwe, D. Dutta, J.T. Stanley, G. A. Walter, W. Tan, B. M. Moudgil and R. A. Mericle, "Synthesis and Characterization of fluorescent, Radio-opaque, and Paramagnetic Silica Nanoparticles for multimodal Bioimagin Applications", Adv. Mat., 17 (2005), 2165-2169,
[12] Demande internationale WO 2007/083036-A1 publiée le 26 juillet 2007,
[13] J. P. Cross, P. G. Sammes, J. Chem. Research. (S) 2003, 704,
[14] C. Gateau, M. Mazzanti, J. Pécaut, F. Dunand, A, L. Helm, Dalton Trans. 2003, 2428,
[15] J. W. Goodwin and al. ; Colloid Polym. Sci. 268, 766-777, 1990,
[16] Jesionowski T.1; Krysztafkiewicz A. ; "Colloids and Surfaces A: Physicochemical and Engineering Aspects", Volume 207, Number 1, 30 juillet 2002, pp. 49-58(10),
[17] Z. Wu and al. ; Journal of Colloid and Interface Science 304 (2006) 119-124,
[18] W. Ströber, A. Fink et E. J. Bohn, J. Coll. Interface Sci, 1968, 26, 62.

## Revendications

1. Particule de silice comprenant au moins un complexe d'au moins un lanthanide et d'au moins un ligand de formule (A): 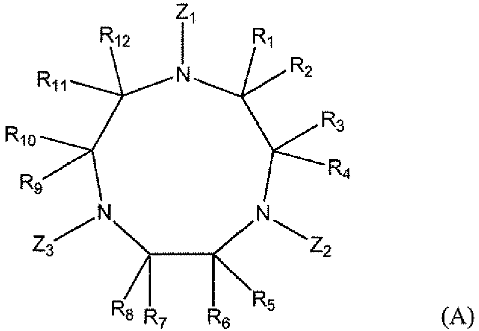 dans laquelle
- Z₁, Z₂ et Z₃, identiques ou différents, représentent chacun un groupement portant un atome porteur d'un doublet libre et/ou d'une charge négative,
- R₁, R₂, R₃, R₄, R₅, R₆, R₇, R₈, R₉, R₁₀, R₁₁ et R₁₂, identiques ou différents, représentent chacun un hydrogène, un radical alkyle éventuellement substitué, un radical aryle éventuellement substitué, un halogène, un groupe -OR₁₃ ou un groupe -SR₁₃, avec R₁₃ représentant H, un groupe alkyle éventuellement substitué ou un groupe aryle éventuellement substitué,
**caractérisé en ce que** au moins un groupement portant un atome porteur d' un doublet libre d'électrons et/ou d'une charge négative est choisi dans le groupe constitué par les groupements de formules (B), (C), (D), (E), (F) et (H) : 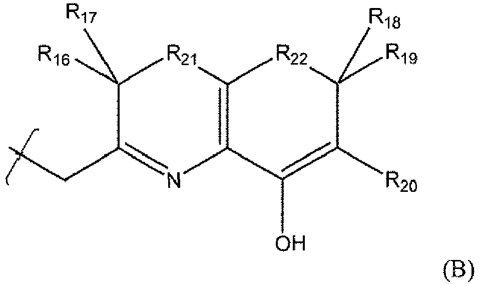 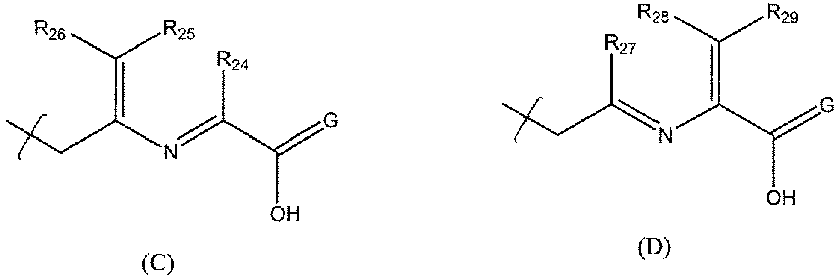 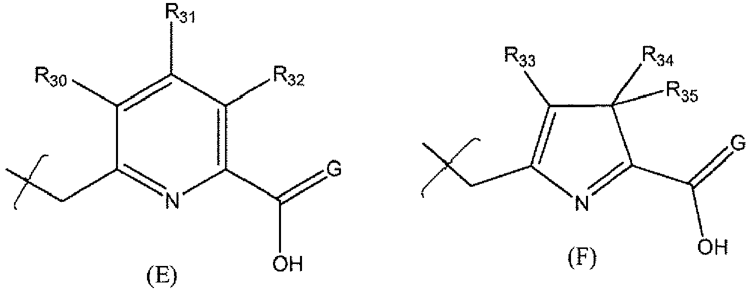 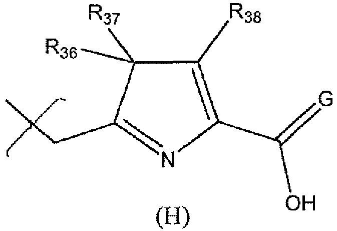 dans lesquelles
- R₂₁ représente une liaison simple ou R₂₁ représente un radical =CR₂₃-, R₁₇ étant alors absent ;
- R₂₂ représente une liaison simple ou R₂₂ représente un radical -CR₂₃=, R₁₉ étant alors absent ;
- G représente un O, N, P, S ou un C substitué indépendamment par un hydrogène, un radical alkyle éventuellement substitué ou un radical aryle éventuellement substitué,
- les radicaux R₁₆, R₁₇, R₁₈, R₁₉, R₂₀, R₂₃, R₂₄, R₂₅, R₂₆, R₂₇, R₂₈, R₂₉, R₃₀, R₃₁, R₃₂, R₃₃, R₃₄, R₃₅, R₃₆, R₃₇ et R₃₈, identiques ou différents, représentent un hydrogène, un radical alkyl éventuellement substitué, un radical aryle éventuellement substitué, un halogène, un radical -SO₃H, un radical -SO₃⁻, un groupe -OR₁₃ ou un groupe -SR₁₃, avec R₁₃ représentant H, un groupe alkyl éventuellement substitué ou un groupe aryle éventuellement substitué.

2. Particule de silice selon la revendication 1, **caractérisée en ce que** ledit groupement de formule (B) est choisi parmi :
- le groupement (B₁) de formule (B) dans lequel R₂₂ représente un radical -C(SO₃⁻)= et R₁₆, R₁₇, R₁₈, et R₂₀ étant tels que définis à la revendication 1 ;
- le groupement (B₂) de formule (B) dans lequel R₁₆ = R₁₈ = R₂₀ = H ; R₂₁ = un radical =CH- et R₂₂ = un radical -CH=, R₁₇ et R₁₉ étant absents ;
- le groupement (B₃) de formule (B) dans lequel R₁₆ = R₁₈ = R₂₀ = H ; R₂₁ = un radical =CH- et R₂₂ = un radical -C (SO₃⁻) =, R₁₇ et R₁₉ étant absents.

3. Particule de silice selon la revendication 1 ou 2, **caractérisée en ce que** lesdits groupements Z₁, Z₂ et Z₃ sont identiques.

4. Particule de silice selon l'une quelconque des revendications précédentes, **caractérisée en ce que** ledit ligand est choisi parmi :

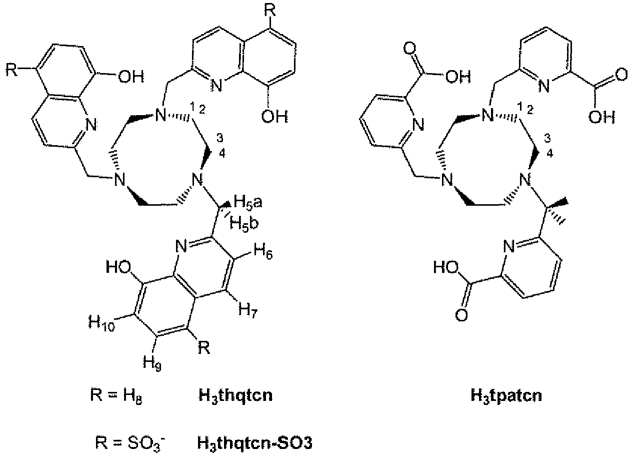

5. Particule de silice selon l'une quelconque des revendications précédentes, **caractérisée en ce que** ledit lanthanide est choisi dans le groupe constitué par le cérium (Ce), le néodyme (Nd), l'europium (Eu), le gadolinium (Gd), le terbium (Tb), l'erbium (Er) et l'ytterbium (Yb).

6. Particule de silice selon l'une quelconque des revendications précédentes, **caractérisée en ce que** ledit complexe se trouve sous forme de complexe de coordination de formule générale (I)
[Ln(L)(H₂O)ₙ] (I)
dans laquelle Ln représente un lanthanide tel que défini à la revendication 1 ou 5, L est un ligand de formule (A) tel que défini à l'une quelconque des revendications 1 à 4, et n est un entier variant de 0 à 6.

7. Particule de silice selon l'une quelconque des revendications précédentes, **caractérisée en ce que** ladite particule est de tailles nanométrique à micrométrique.

8. Particule de silice selon l'une quelconque des revendications précédentes, **caractérisée en ce que** ledit complexe est encapsulé dans ladite particule de silice.

9. Particule de silice selon la revendication 8, **caractérisée en ce que** ladite particule de silice est fonctionnalisée.

10. Particule de silice selon l'une quelconque des revendications 1 à 7, **caractérisée en ce que** ledit complexe se trouve en surface de ladite particule.

11. Procédé de préparation d'une particule de silice comprenant au moins un complexe d'au moins un lanthanide et d'au moins un ligand de formule (A) telle que définie à la revendication 10 comprenant les étapes suivantes :
a') à greffer, de façon directe ou indirecte, sur une particule de silice au moins un ligand de formule (A) tel que défini à l'une quelconque des revendications 1 à 4 éventuellement complexé avec au moins un lanthanide tel que défini à la revendication 1 ou 5,
b') éventuellement mettre en contact la particule de silice greffée obtenue à l'étape (a') avec au moins un lanthanide tel que défini à la revendication 1 ou 5.

12. Procédé de préparation d'une particule de silice comprenant au moins un complexe d'au moins un lanthanide et d'au moins un ligand de formule (A) telle que définie à l'une quelconque des revendications 8 ou 9, **caractérisé en ce que** ledit procédé comprend les étapes consistant à :
a) encapsuler, dans une particule de silice, au moins un complexe comprenant au moins un lanthanide et au moins un ligand de formule (A) tel que défini à l'une quelconque des revendications 1 à 6 et
b) éventuellement fonctionnaliser ladite particule de silice obtenue à l'étape (a).

13. Procédé selon la revendication 12, **caractérisé en ce que** ladite étape (a) consiste à :
c) utiliser une particule de silice sur laquelle est greffé au moins un complexe comprenant au moins un lanthanide et au moins un ligand de formule (A) susceptible d'être obtenue par le procédé tel que défini à la revendication 11, puis
d) enrober ladite particule par une couche de silice.

14. Procédé selon la revendication 12, **caractérisé en ce que** ladite étape (a) consiste à :
e) mettre en contact une particule de silice poreuse avec au moins un ligand de formule (A) tel que défini à l'une quelconque des revendications 1 à 4 éventuellement complexé avec au moins un lanthanide tel que défini à la revendication 1 ou 5,
f) éventuellement, mettre en contact la particule de silice obtenue à l'étape (e) avec au moins un lanthanide tel que défini à à revendication 1 ou 5,
g) éventuellement, enrober la particule obtenue à l'étape (f) par une couche de silice.

15. Procédé selon la revendication 12, **caractérisé en ce que** ladite étape (a) consiste à :
h) mettre en contact au moins un complexe comprenant au moins un lanthanide et au moins un ligand de formule (A) tel que défini à l'une quelconque des revendications 1 à 6 avec au moins un précurseur de silice dans des conditions permettant d'obtenir une particule de silice,
i) éventuellement, enrober ladite particule obtenue à l'étape (h) par une couche de silice.

16. Utilisation d'une particule de silice telle que définie dans l'une quelconque des revendications 1 à 10 ou d'une particule de silice susceptible d'être préparée par un procédé tel que défini à l'une quelconque des revendications 11 à 15, en tant que traceur pour la biologie.

17. Utilisation d'une particule de silice telle que définie dans l'une quelconque des revendications 1 à 10 ou d'une particule de silice susceptible d'être préparée par un procédé tel que défini à l'une quelconque des revendications 11 à 15, en tant que traceur de marquage anti-contrefaçon.

## Patentansprüche

1. Quarzpartikel, umfassend wenigstens einen Komplex aus wenigstens einem Lanthanoid und wenigstens einem Liganden der Formel (A): 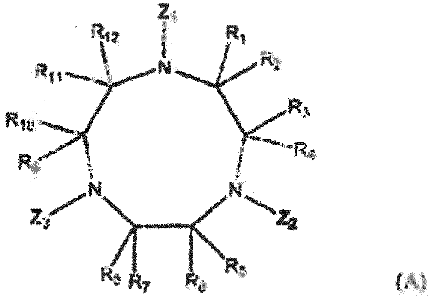 wobei
- Z₁, Z₂ und Z₃, die identisch oder unterschiedlich sind, jeweils eine Gruppe darstellen, die ein Atom trägt, welches Träger eines freien Doublets und/oder einer negativen Ladung ist,
- R₁, R₂, R₃, R₄, R₅, R₆, R₇, R₈, R₉, R₁₀, R₁₁ und R₁₂, die identisch oder unterschiedlich sind, jeweils einen Wasserstoff, ein gegebenenfalls substituiertes Alkylradikal, ein gegebenenfalls substituiertes Arylradikal, ein Halogen, eine Gruppe -OR₁₃ oder eine Gruppe -SR₁₃ darstellen, wobei R₁₃ H, eine gegebenenfalls substituierte Alkylgruppe oder eine gegebenenfalls substituierte Arylgruppe darstellt,
**dadurch gekennzeichnet, dass** wenigstens eine Gruppe, die ein Atom trägt, welches Träger eines freien Doublets von Elektronen und/oder einer negativen Ladung ist, ausgewählt ist aus der Gruppe gebildet durch die Gruppen mit den Formeln (B), (C), (D), (E), (F) und (H): 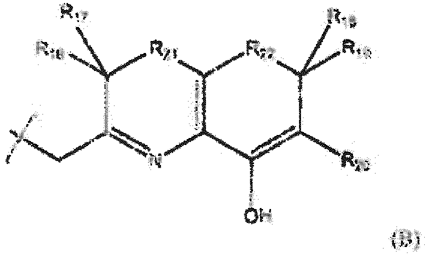 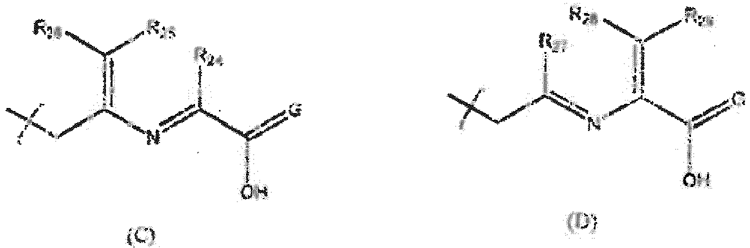 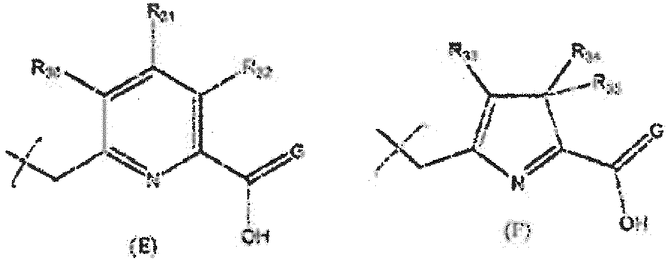 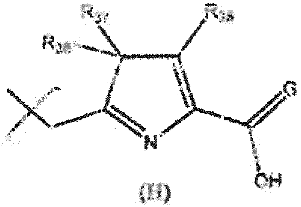 wobei
- R₂₁ eine Einfachbindung darstellt, oder R₂₁ ein Radikal =CR₂₃- darstellt, wobei R₁₇ dann abwesend ist;
- R₂₂ eine Einfachbindung darstellt, oder R₂₂ ein Radikal -CR₂₃= darstellt, wobei R₁₉ dann abwesend ist;
- G ein O, N, P, S oder ein C darstellt, gegebenenfalls unabhängig durch einen Wasserstoff substituiert, ein gegebenenfalls substituiertes Alkylradikal oder ein gegebenenfalls substituiertes Arylradikal,
- die Radikale R₁₆, R₁₇, R₁₈, R₁₉, R₂₀, R₂₃, R₂₄, R₂₅, R₂₆, R₂₇, R₂₈, R₂₉, R₃₀, R₃₁, R₃₂, R₃₃, R₃₄, R₃₅, R₃₆, R₃₇ und R₃₈, die identisch oder verschieden sind, einen Wasserstoff, ein gegebenenfalls substituiertes Alkylradikal, ein gegebenenfalls substituiertes Arylradikal, ein Halogen, ein Radikal -SO₃H, ein Radikal -SO₃⁻, eine Gruppe -OR₁₃ oder eine Gruppe -SR₁₃ darstellen, wobei R₁₃ H, eine gegebenenfalls substituierte Alkylgruppe oder eine gegebenenfalls substituierte Arylgruppe darstellt.

2. Quarzpartikel nach Anspruch 1, **dadurch gekennzeichnet, dass** die Gruppe der Formel (B) ausgewählt ist aus:
- die Gruppe (B₁) der Formel (B), in der R₂₂ ein Radikal -C(SO₃⁻)= darstellt, und R₁₆, R₁₇, R₁₈ und R₂₀ wie in Anspruch 1 definiert sind;
- der Gruppe (B₂) der Formel (B), in der R₁₆ = R₁₈ = R₂₀ = H; R₂₁ = ein Radikal =CH- und R₂₂ = ein Radikal-CH=, wobei R₁₇ und R₁₉ abwesend sind;
- der Gruppe (B₃) der Formel (B), in der R₁₆= R₁₈ = R₂₀ = H; R₂₁= ein Radikal =CH- und R₂₂ = ein Radikal -C(SO₃⁻)=, wobei R₁₇ und R₁₉ abwesend sind.

3. Quarzpartikel nach Anspruch 1 oder 2, **dadurch gekennzeichnet, dass** die Gruppen Z₁, Z₂ und Z₃ identisch sind.

4. Quarzpartikel nach einem der vorhergehenden Ansprüche, **dadurch gekennzeichnet, dass** der Ligand ausgewählt ist aus:

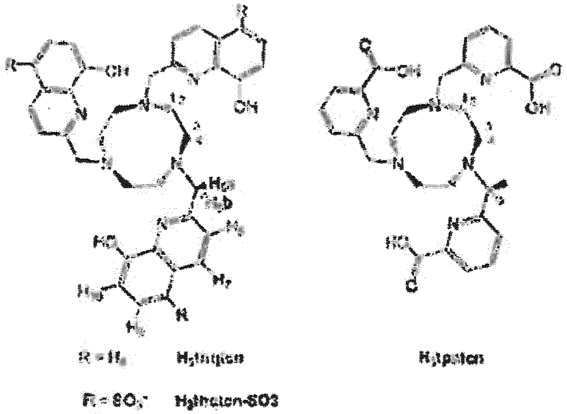

5. Quarzpartikel nach einem der vorhergehenden Ansprüche, **dadurch gekennzeichnet, dass** das Lanthanoid ausgewählt ist aus der Gruppe gebildet durch Cer (Ce), Neodym (Nd), Europium (Eu), Gadolinium (Gd), Terbium (Tb), Erbium (Er) und Ytterbium (Yb).

6. Quarzpartikel nach einem der vorhergehenden Ansprüche, **dadurch gekennzeichnet, dass** der Komplex in Form eines Koordinationskomplexes der allgemeinen Formel (I) vorliegt:
[Ln(L)(H₂O)ₙ] (I)
wobei Ln ein Lanthanoid wie in Anspruch 1 oder 5 definiert darstellt, L ein Ligand der Formel (A) wie in einem der Ansprüche 1 bis 4 definiert ist, und n eine ganze Zahl zwischen 0 und 6 ist.

7. Quarzpartikel nach einem der vorhergehenden Ansprüche, **dadurch gekennzeichnet, dass** das Partikel nanometrische bis mikrometrische Größen hat.

8. Quarzpartikel nach einem der vorhergehenden Ansprüche, **dadurch gekennzeichnet, dass** der Komplex in dem Quarzpartikel gekapselt ist.

9. Quarzpartikel nach Anspruch 8, **dadurch gekennzeichnet, dass** das Quarzpartikel funktionalisiert ist.

10. Quarzpartikel nach einem der Ansprüche 1 bis 7, **dadurch gekennzeichnet, dass** sich der Komplex an der Oberfläche des Partikels befindet.

11. Verfahren zur Herstellung eines Quarzpartikels, umfassend wenigstens einen Komplex aus wenigstens einem Lanthanoid und wenigstens einem Liganden der Formel (A) wie in Anspruch 10 definiert, umfassend die folgenden Schritte:
a') direktes oder indirektes Pfropfen wenigstens eines Liganden der Formel (A) wie in einem der Ansprüche 1 bis 4 definiert, gegebenenfalls mit wenigstens einem Lanthanoid wie in Anspruch 1 oder 5 definiert komplexiert, auf ein Quarzpartikel,
b') gegebenenfalls Inkontaktbringen des im Schritt (a') erhaltenen gepfropften Quarzpartikels mit wenigstens einem Lanthanoid wie in Anspruch 1 oder 5 definiert.

12. Verfahren zur Herstellung eines Quarzpartikels, umfassend wenigstens einen Komplex aus wenigstens einem Lanthanoid und wenigstens einem Ligand der Formel (A) wie in einem der Ansprüche 8 oder 9 definiert, **dadurch gekennzeichnet, dass** das Verfahren die folgenden Schritte umfasst:
a) Kapseln wenigstens eines Komplexes, umfassend wenigstens ein Lanthanoid und wenigstens einen Liganden der Formel (A) wie in einem der Ansprüche 1 bis 6 definiert, in einem Quarzpartikel, und
b) gegebenenfalls Funktionalisieren des im Schritt (a) erhaltenen Quarzpartikels.

13. Verfahren nach Anspruch 12, **dadurch gekennzeichnet, dass** der Schritt (a) umfasst:
c) Verwenden eines Quarzpartikels, auf das wenigstens ein Komplex gepfropft ist, umfassend wenigstens ein Lanthanoid und wenigstens einen Liganden der Formel (A), erhältlich durch das Verfahren wie in Anspruch 11 definiert, und anschließend
d) Umhüllen des Partikels mit einer Quarzschicht.

14. Verfahren nach Anspruch 12, **dadurch gekennzeichnet, dass** der Schritt (a) umfasst:
e) Inkontaktbringen eines Partikels aus porösem Quarz mit wenigstens einem Liganden der Formel (A) wie in einem der Ansprüche 1 bis 4 definiert, gegebenenfalls komplexiert mit wenigstens einem Lanthanoid, wie in Anspruch 1 oder 5 definiert,
f) gegebenenfalls Inkontaktbringen des im Schritt (e) erhaltenen Quarzpartikels mit wenigstens einem Lanthanoid wie in Anspruch 1 oder 5 definiert,
g) gegebenenfalls Umhüllen des im Schritt (f) erhaltenen Partikels mit einer Quarzschicht.

15. Verfahren nach Anspruch 12, **dadurch gekennzeichnet, dass** der Schritt (a) umfasst:
h) Inkontaktbringen wenigstens eines Komplexes, umfassend wenigstens ein Lanthanoid und wenigstens einen Liganden der Formel (A) wie in einem der Ansprüche 1 bis 6 definiert, mit wenigstens einem Quarzprekursor unter Bedingungen, die es erlauben, ein Quarzpartikel zu erhalten,
i) gegebenenfalls Umhüllen des im Schritt (h) erhaltenen Partikels mit einer Quarzschicht.

16. Verwendung eines Quarzpartikels wie in einem der Ansprüche 1 bis 10 definiert, oder eines Quarzpartikel, das durch ein Verfahren wie in einem der Ansprüche 11 bis 15 definiert herstellbar ist, als Tracer für die Biologie.

17. Verwendung eines Quarzpartikels wie in einem der Ansprüche 1 bis 10 definiert oder eines Quarzpartikels, das durch ein Verfahren wie in einem der Ansprüche 11 bis 15 definiert herstellbar ist, als Tracer für eine Antifälschungsmarkierung.

## Claims

1. Silica particle comprising at least one complex of at least one lanthanide and at least one ligand of formula (A) : 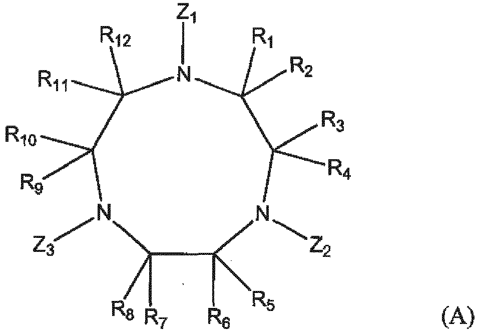 in which
- Z₁, Z₂ and Z₃, which may be identical or different, each represent a group bearing an atom bearing a lone pair and/or a negative charge,
- R₁, R₂, R₃, R₄, R₅, R₆, R₇, R₈, R₉, R₁₀, R₁₁ and R₁₂, which may be identical or different, each represent a hydrogen, an optionally substituted alkyl radical, an optionally substituted aryl radical, a halogen, a group -OR₁₃ or a group -SR₁₃, with R₁₃ representing H, an optionally substituted alkyl group or an optionally substituted aryl group,
**characterized in that** at least one group bearing an atom bearing a lone pair and/or a negative charge is chosen from the group constituted by the groups of formulae (B), (C), (D), (E), (F) and (H): 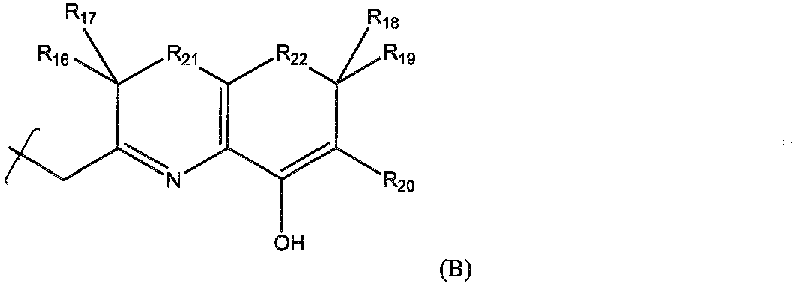 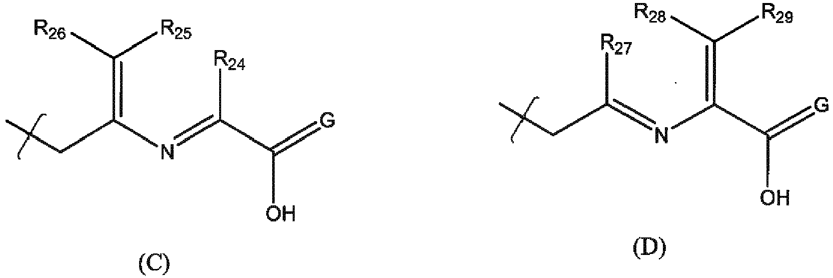 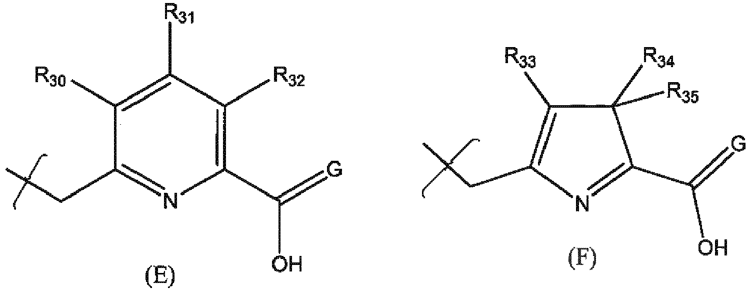 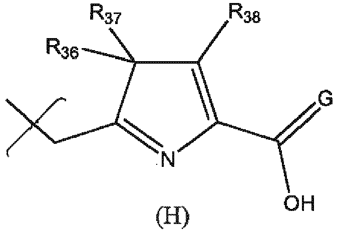 in which
- R₂₁ represents a single bond or R₂₁ represents a radical =CR₂₃-, R₁₇ then being absent;
- R₂₂ represents a single bond or R₂₂ represents a radical -CR₂₃=, R₁₉ then being absent;
- G represents an O, N, P, S or a C independently substituted with a hydrogen, an optionally substituted alkyl radical or an optionally substituted aryl radical,
- the radicals R₁₆, R₁₇, R₁₈, R₁₉, R₂₀, R₂₃, R₂₄, R₂₅, R₂₆, R₂₇, R₂₈, R₂₉, R₃₀, R₃₁, R₃₂, R₃₃, R₃₄, R₃₅, R₃₆, R₃₇ and R₃₈, which may be identical or different, represent a hydrogen, an optionally substituted alkyl radical, an optionally substituted aryl radical, a halogen, a radical -SO₃H, a radical -SO₃⁻, a group -OR₁₃ or a group -SR₁₃, with R₁₃ representing H, an optionally substituted alkyl group or an optionally substituted aryl group.

2. Silica particle according to claim 1, **characterized in that** said group of formula (B) is chosen from:
- the group (B₁) of formula (B) in which R₂₂ represents a radical -C(SO₃⁻)= and R₁₆, R₁₇, R₁₈, and R₂₀ are as defined in claim 1;
- the group (B₂) of formula (B) in which R₁₆ = R₁₈ = R₂₀ = H; R₂₁ = a radical =CH- and R₂₂ = a radical -CH=, R₁₇ and R₁₉ being absent;
- the group (B₃) of formula (B) in which R₁₆ = R₁₈ = R₂₀ = H; R₂₁ = a radical =CH- and R₂₂ = a radical -C(SO₃⁻)=, R₁₇ and R₁₉ being absent.

3. Silica particle according to claim 1 or 2, **characterized in that** said groups Z₁, Z₂ and Z₃ are identical.

4. Silica particle according to any one of the preceding claims, **characterized in that** said ligand is chosen from :

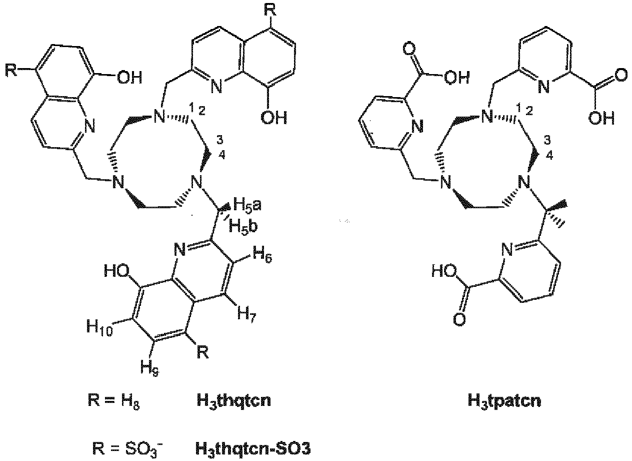

5. Silica particle according to any one of the preceding claims, **characterized in that** said lanthanide is chosen from the group constituted by cerium (Ce), neodymium (Nd), europium (Eu), gadolinium (Gd), terbium (Tb), erbium (Er) and ytterbium (Yb).

6. Silica particle according to any one of the preceding claims, **characterized in that** said complex is in the form of a coordination complex of general formula (I)
[Ln(L)(H₂O)ₙ] (I)
in which Ln represents a lanthanide as defined in claim 1 or 5, L is a ligand of formula (A) as defined in any one of claims 1 to 4, and n is an integer ranging from 0 to 6.

7. Silica particle according to any one of the preceding claims, **characterized in that** said particle is of nanometric to micrometric sizes.

8. Silica particle according to any one of the preceding claims, **characterized in that** said complex is encapsulated in said silica particle.

9. Silica particle according to claim 8, **characterized in that** said silica particle is functionalized.

10. Silica particle according to any one of claims 1 to 7, **characterized in that** said complex is at the surface of said particle.

11. Process for preparing a silica particle comprising at least one complex of at least one lanthanide and of at least one ligand of formula (A) as defined in claim 10, comprising the following steps:
a') grafting, directly or indirectly, onto a silica particle at least one ligand of formula (A) as defined in any one of claims 1 to 4 optionally complexed with at least one lanthanide as defined in claim 1 or 5,
b') optionally placing in contact the grafted silica particle obtained in step (a') with at least one lanthanide as defined in claim 1 or 5.

12. Process for preparing a silica particle comprising at least one complex of at least one lanthanide and of at least one ligand of formula (A) as defined in claim 8 or 9, **characterized in that** said process comprises the steps consisting in:
a) encapsulating, in a silica particle, at least one complex comprising at least one lanthanide and at least one ligand of formula (A) as defined in any one of claims 1 to 6, and
b) optionally functionalizing said silica particle obtained in step (a).

13. Process according to claim 12, **characterized in that** said step (a) consists in:
c) using a silica particle onto which is grafted at least one complex comprising at least one lanthanide and at least one ligand of formula (A) that may be obtained via the process as defined in claim 11, and then
d) coating said particle with a layer of silica.

14. Process according to claim 12, **characterized in that** said step (a) consists in:
e) placing in contact a porous silica particle with at least one ligand of formula (A) as defined in any one of claims 1 to 4 optionally complexed with at least one lanthanide as defined in claim 1 or 5,
f) optionally, placing in contact the silica particle obtained in step (e) with at least one lanthanide as defined in claim 1 or 5,
g) optionally, coating the particle obtained in step (f) with a layer of silica.

15. Process according to claim 12, **characterized in that** said step (a) consists in:
h) placing in contact at least one complex comprising at least one lanthanide and at least one ligand of formula (A) as defined in any one of claims 1 to 6 with at least one silica precursor under conditions for obtaining a silica particle,
i) optionally, coating said particle obtained in step (h) with a layer of silica.

16. Use of a silica particle as defined in any one of claims 1 to 10 or of a silica particle that may be prepared via a process as defined in any one of claims 11 to 15, as a biological tracer.

17. Use of a silica particle as defined in any one of claims 1 to 10 or of a silica particle that may be prepared via a process as defined in any one of claims 11 to 15, as a tracer for anti-counterfeit marking.
